# EUROPÄISCHE PATENTSCHRIFT

(11) **EP 2 898 042 B1**
(45) Veröffentlichungstag und Bekanntmachung des Hinweises auf die Patenterteilung: **06.07.2016**
(21) Anmeldenummer: 13755957.1
(22) Anmeldetag: 20.08.2013
(51) Int. Cl.: C09K 11/06, H01L 51/50, H05B 33/22

(54) **MATERIALIEN FÜR ELEKTRONISCHE VORRICHTUNGEN**
MATERIALS FOR ELECTRONIC DEVICES
MATÉRIAUX POUR DISPOSITIFS ÉLECTRONIQUES

(30) Priorität: 18.09.2012 EP 12006553
(43) Veröffentlichungstag der Anmeldung: 29.07.2015
(73) Patentinhaber: Merck Patent GmbH, 64293 Darmstadt (DE)
(72) Erfinder: STOESSEL, Philipp, 60487 Frankfurt am Main (DE); VOGES, Frank, 67098 Bad Duerkheim (DE); BUESING, Arne, 65929 Frankfurt am Main (DE); PFLUMM, Christof, 64291 Darnstadt-Arheilgen (DE); MUJICA-FERNAUD, Teresa, 64283 Darmstadt (DE); KROEBER, Jonas, Valentin, 60311 Frankfurt am Main (DE)
(86) Internationale Anmeldenummer: PCT/EP2013/002501
(87) Internationale Veröffentlichungsnummer: WO 2014/044344

(56) Entgegenhaltungen:
- EP-A1- 0 650 955
- EP-A1- 1 834 945
- EP-A1- 1 885 008
- JP-A- H0 753 955
- JP-A- 2001 226 331
- JP-A- 2010 222 268

## Beschreibung

Die vorliegende Anmeldung betrifft eine Mischung enthaltend mindestens zwei verschiedene Verbindungen einer Formel (I). Die Mischung eignet sich zur Verwendung in elektronischen Vorrichtungen, insbesondere organischen Elektrolumineszenzvorrichtungen, insbesondere in einer lochtransportierenden Schicht.

Unter elektronischen Vorrichtungen im Sinne dieser Anmeldung werden insbesondere sogenannte organische elektronische Vorrichtungen verstanden (organic electronic devices), welche organische Halbleitermaterialien als Funktionsmaterialien enthalten. Nochmals insbesondere werden darunter organische Elektrolumineszenzvorrichtungen (OLEDs) und andere elektronische Vorrichtungen verstanden, die weiter unten aufgeführt sind.

OLEDs erreichen in vielen Punkten bereits hervorragende Ergebnisse, es liegt jedoch weiterhin Verbesserungsbedarf vor, insbesondere in Bezug auf Leistungseffizienz, Lebensdauer und Farbkoordinaten des emittierten Lichts. Zur Verbesserung der Eigenschaften besteht hohes Interesse an neuen Materialien und Mischungen zur Verwendung in den Vorrichtungen.

Im Stand der Technik bekannt ist die Verwendung von einfachen Triarylamino-Verbindungen wie beispielsweise Tris-(para-biphenyl)amin oder Tris-(para-triphenyl)amin (JP 1995/053955 A) in OLEDs. Weiterhin bekannt ist die Verwendung von einfachen Triarylamino-Verbindungen, welche para- und meta-Verknüpfungen der einzelnen Phenylgruppen aufweisen (WO 2006/123667 A1 und JP 2010/222268 A). Die genannten Verbindungen werden bevorzugt als Lochtransportmaterialien verwendet. Sie sind einfach und kostengünstig hochrein herstellbar und sind daher sehr attraktiv für die Verwendung als Funktionsmaterialien in OLEDs.

Die genannten Verbindungen weisen jedoch die Eigenschaft auf, bei Erhitzen über die Glasübergangstemperatur teilweise zu kristallisieren. Dies führt typischerweise zu einer Verschlechterung der Leistungsdaten der OLEDs im Betrieb, da mit dem Betrieb eine Erwärmung der OLEDs verbunden ist.

Es stellt sich daher die technische Aufgabe, Materialien bereitzustellen, welche einen konstanten Erhalt der Leistungsdaten der OLEDs im Betrieb ermöglichen, d .h. unter betriebsbedingter Erwärmung oder bei Erwärmung der OLED aufgrund anderer Ursachen, beispielsweise erhöhten Umgebungstemperaturen.

Diese Aufgabe wird erfindungsgemäß gelöst durch eine Mischung enthaltend zwei oder mehr verschiedene Verbindungen der Formel (I) 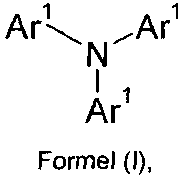 wobei für die Verbindungen der Formel (I) gilt:
- Ar¹: ist bei jedem Auftreten gleich oder verschieden ein aromatisches oder heteroaromatisches Ringsystem mit 5 bis 60 aromatischen Ringatomen, das mit einem oder mehreren Resten R¹ substituiert sein kann;
- R¹: ist bei jedem Auftreten gleich oder verschieden H, D, F, C(=O)R², CN, Si(R²)₃, P(=O)(R²)₂, S(=O)R², S(=O)₂R₂, eine geradkettige Alkyl-, Alkoxy- oder Thioalkylgruppe mit 1 bis 20 C-Atomen oder eine verzweigte oder cyclische Alkyl-, Alkoxy- oder Thioalkylgruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R² substituiert sein können und wobei eine oder mehrere CH₂-Gruppen in den oben genannten Gruppen durch - R²C=CR²-, -C≡C-, Si(R²)₂, C=O, C=S, C=NR², -C(=O)O-, -C(=O)NR²-, P(=O)(R²), -O-, -S-, SO oder SO₂ ersetzt sein können und wobei ein oder mehrere H-Atome in den oben genannten Gruppen durch D, F oder CN ersetzt sein können, oder ein aromatisches oder hetero-aromatisches Ringsystem mit 5 bis 30 aromatischen Ringatomen, das jeweils durch einen oder mehrere Reste R² substituiert sein kann, oder eine Aryloxy- oder Heteroaryloxygruppe mit 5 bis 30 aromatischen Ringatomen, die durch einen oder mehrere Reste R² substituiert sein kann, wobei zwei oder mehr Reste R¹ miteinander verknüpft sein können und einen Ring bilden können;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden;
wobei eine, zwei oder drei Gruppen Ar¹ gleich oder verschieden gewählt sind aus aromatischen Ringsystemen mit 12 bis 60 aromatischen Ringatomen, die mit einem oder mehreren Resten R¹ substituiert sein können.

Die Mischungen weisen den überraschenden Vorteil auf, dass sie bei Erhitzen über die Glasübergangstemperatur wenig oder gar nicht zur Kristallisation neigen. OLEDs enthaltend die erfindungsgemäße Mischung weisen sie den überraschenden Vorteil auf, dass sie ihre Leistungsdaten auch bei Erwärmung beibehalten. Weiterhin haben OLEDs enthaltend die erfindungsgemäße Mischung den Vorteil, dass sie eine reduzierte Spannung bei ansonsten gleichbleibenden Leistungsdaten aufweisen.

Folgende Definitionen gelten:
Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt ausgewählt aus N, *O* und S. Dies stellt die grundlegende Definition dar. Werden in der Beschreibung der vorliegenden Erfindung andere Bevorzugungen angegeben, beispielsweise bezüglich der Zahl der aromatischen Ringatome oder der enthaltenen Heteroatome, so gelten diese.

Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin oder Thiophen, oder ein kondensierter (annellierter) aromatischer bzw. heteroaromatischer Polycyclus, beispielsweise Naphthalin, Phenanthren, Chinolin oder Carbazol verstanden. Ein kondensierter (annellierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einer Aryloxygruppe gemäß der Definition der vorliegenden Erfindung wird eine Arylgruppe, wie oben definiert, verstanden, welche über ein Sauerstoffatom gebunden ist. Eine analoge Definition gilt für Heteroaryloxygruppen.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, Si-, N- oder O-Atom, ein sp²-hybridisiertes C- oder N-Atom oder ein sp-hybridisiertes C-Atom, verbunden sein können. So sollen beispielsweise auch Systeme wie 9,9'-Spirobifluoren, 9,9'-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 - 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Kombinationen dieser Gruppen.

Im Rahmen der vorliegenden Erfindung werden unter einer geradkettigen Alkylgruppe mit 1 bis 40 C-Atomen bzw. einer verzweigten oder cyclischen Alkylgruppe mit 3 bis 40 C-Atomen bzw. einer Alkenyl- oder Alkinylgruppe mit 2 bis 40 C-Atomen, in der auch einzelne H-Atome oder CH₂-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxy- oder Thioalkylgruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Dies wird durch das folgende Schema verdeutlicht:

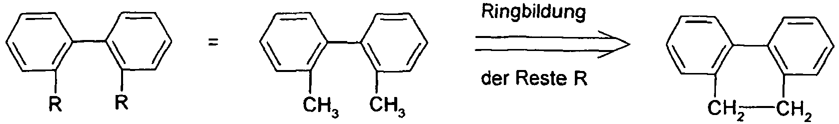

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

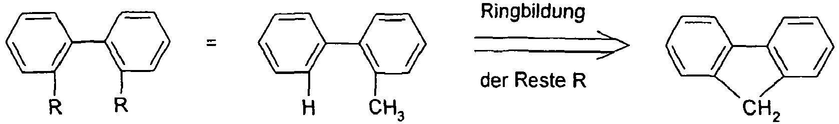

Bevorzugt enthält die erfindungsgemäße Mischung genau zwei, drei oder vier verschiedene Verbindungen der Formel (I), besonders bevorzugt genau zwei oder drei.

Die Mischung kann zusätzlich zu den mindestens zwei Verbindungen der Formel (I) weitere Verbindungen enthalten. Dabei ist es bevorzugt, dass diese in geringem Anteil vorliegen, besonders bevorzugt in einem Anteil von weniger als 20 %.

Im Rahmen der vorliegenden Anmeldung wird unter "%" Gewichtsprozent verstanden, sofern eine Aufbringung der Materialien aus Lösung erfolgt, beispielsweise durch einen Druckprozess, und es wird unter "%" Volumenprozent verstanden, sofern es sich um eine Aufbringung aus der Gasphase handelt, beispielsweise durch Verdampfung. Bevorzugt wird unter "%" im Rahmen der vorliegenden Anmeldung Gewichtsprozent verstanden.

Es ist besonders bevorzugt, dass die erfindungsgemäße Mischung weniger als 10 % an Verbindungen enthält, die nicht Formel (I) entsprechen. Ganz besonders bevorzugt enthält sie weniger als 5 %, stärker bevorzugt weniger als 2 % und noch stärker bevorzugt weniger als 1 % an Verbindungen, die nicht Formel (I) entsprechen.

Am stärksten bevorzugt ist es, dass die Mischung im Wesentlichen keine weiteren Verbindungen neben den mindestens zwei Verbindungen gemäß Formel (I) aufweist.

Verbindungen, die neben den Verbindungen gemäß Formel (I) in den erfindungsgemäßen Mischungen enthalten sind, sind bevorzugt gewählt aus solchen Verbindungen, die typischerweise als Komponenten von Lochtransportschichten, Lochinjektionsschichten oder Elektronenblockierschichten in OLEDs verwendet werden. Bevorzugt sind Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449) oder Dibenzoindenofluorenamine (z. B. gemäß WO 07/140847). Weiterhin können Derivate dieser Verbindungen, wie sie in JP 2001/226331, EP 676461, EP 650955, WO 01/049806, US 4780536, WO 98/30071, EP 891121, EP 1661888, JP 2006/253445, EP 650955, WO 06/073054 und US 5061569 offenbart werden, vorhanden sein.

Gemäß einer bevorzugten Ausführungsform enthält die Mischung einen oder mehrere p-Dotanden. Als p-Dotanden werden gemäß der vorliegenden Erfindung bevorzugt solche organischen Elektronenakzeptorverbindungen eingesetzt, die eine oder mehrere der anderen Verbindungen der Mischung oxidieren können. Besonders bevorzugte Ausführungsformen von p-Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709, US 2010/0096600 und WO 2012/095143 offenbarten Verbindungen.

Ganz besonders bevorzugt sind die in US 8057712 offenbarten Radialen-Verbindungen, die in WO 2009/003455 offenbarten chinoiden organischen Verbindungen, die in WO 2011/120709 offenbarten quadratisch planaren Übergangsmetallkomplexe, insbesondere Cu-Komplexe, die in WO 2011/033023 offenbarten mehrkernigen Cu-Komplexe, insbesondere solche mit Carboxylat-Liganden, und die in US 2010/0096600 offenbarten quadratisch planaren Übergangsmetallkomplexe mit Zentralatom aus der 8.-12. Gruppe, insbesondere Nickel.

Besonders bevorzugt als p-Dotanden sind Chinodimethanverbindungen, Azaindenofluorendione, Azaphenalene, Azatriphenylene, I₂, Metallhalogenide, bevorzugt Übergangsmetallhalogenide, Metalloxide, bevorzugt Metalloxide enthaltend mindestens ein Übergangsmetall oder ein Metall der 3. Hauptgruppe, und Übergangsmetallkomplexe, bevorzugt Komplexe von Cu, Co, Ni, Pd und Pt mit Liganden enthaltend mindestens ein Sauerstoffatom als Bindungsstelle. Bevorzugt sind weiterhin Übergangsmetalloxide als Dotanden, bevorzugt Oxide von Rhenium, Molybdän und Wolfram, besonders bevorzugt Re₂O₇, MoO₃, WO₃ und ReO₃.

Ganz besonders bevorzugt sind als p-Dotanden die folgenden Verbindungen:

| | | |
|---|---|---|
| 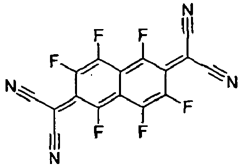 | 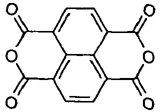 | 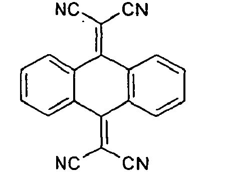 |
| (D-1) | (D-2) | (D-3) |
| | | |
| 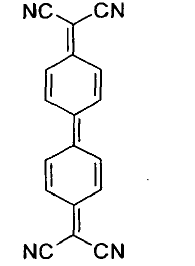 | 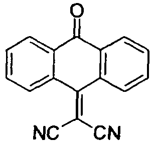 | 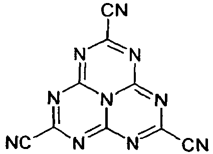 |
| (D-4) | (D-5) | (D-6) |
| | | |
| 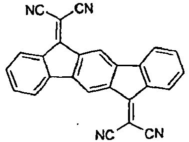 | 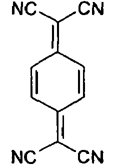 | 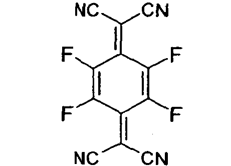 |
| (D-7) | (D-8) | (D-9) |
| | | |
| 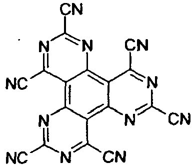 | 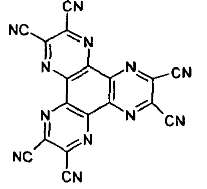 | 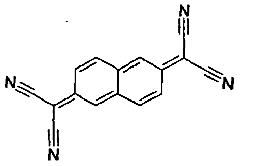 |
| (D-10) | (D-11) | (D-12) |

Wenn p-Dotanden in der Mischung vorliegen, liegen diese bevorzugt in einer Konzentration von 0.1 bis 20 %, besonders bevorzugt 0.5 bis 12 %, ganz besonders bevorzugt 1 bis 8 % und am stärksten bevorzugt 2 bis 6 % vor.

Es ist bevorzugt, dass die mindestens zwei Verbindungen der Formel (I) jede für sich gesehen einen Anteil von mindestens 5 % aufweisen, bevorzugt mindestens 10 %, besonders bevorzugt mindestens 25 % und ganz besonders bevorzugt mindestens 30 %.

Bevorzugt liegen die mindestens zwei Verbindungen der Formel (I) in der erfindungsgemäßen Mischung in jeweils ähnlichen Anteilen vor. Bevorzugt ist der Unterschied in den Anteilen nach % zwischen 0 und 20 Prozentpunkten, besonders bevorzugt zwischen 0 und 10 Prozentpunkten und ganz besonders bevorzugt zwischen 0 und 5 Prozentpunkten.

Betreffend die mindestens zwei Verbindungen gemäß Formel (I) ist es bevorzugt, dass sie außer dem in Formel (I) gezeigten Stickstoffatom kein weiteres Stickstoffstoffatom aufweisen, das drei Substituenten trägt.

Besonders bevorzugt weisen sie außer dem in Formel (I) gezeigten Stickstoffatom kein weiteres Stickstoffatom auf.

Betreffend die mindestens zwei Verbindungen gemäß Formel (I) ist es bevorzugt, dass zwei oder drei Gruppen Ar¹ gewählt sind aus aromatischen Ringsystemen mit 12 bis 60 aromatischen Ringatomen, welche mit einem oder mehreren Resten R¹ substituiert sein können. Bevorzugt sind drei Gruppen Ar¹ gewählt aus aromatischen Ringsystemen mit 12 bis 60 aromatischen Ringatomen, welche mit einem oder mehreren Resten R¹ substituiert sein können.

Ar¹ ist bevorzugt bei jedem Auftreten gleich oder verschieden gewählt aus einem aromatischen oder heteroaromatischen Ringsystem mit 5 bis 30 aromatischen Ringatomen, das mit einem oder mehreren Resten R¹ substituiert sein kann.

Betreffend die mindestens zwei Verbindungen gemäß Formel (I) ist es bevorzugt, dass mindestens eine Gruppe Ar¹ in den Verbindungen der Formel (I) der Formel (II), (III) oder (IV) entspricht 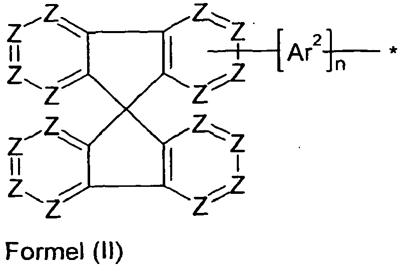 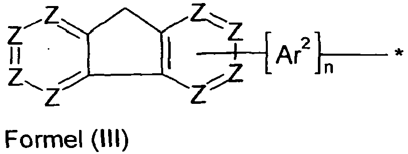 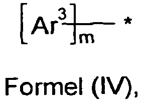
wobei die markierte Bindung der Bindung an das Stickstoffatom entspricht, Z bei jedem Auftreten gleich oder verschieden CR¹ oder N ist, wobei nicht mehr als 2 benachbarte Gruppen Z für N stehen,
Ar² und Ar³ bei jedem Auftreten gleich oder verschieden eine Aryl- oder Heteroarylgruppe mit 5 bis 10 aromatischen Ringatomen ist, die mit einem oder mehreren Resten R¹ substituiert sein kann,
n einen Wert von 0 bis 3 hat,
m einen Wert von 2 bis 4 hat,
und die Gruppen der Formel (II), (III) und (IV) an allen freien Positionen mit Resten R¹ substituiert sein können.

Bevorzugt entsprechen mindestens zwei, besonders bevorzugt alle drei Gruppen Ar¹ in den mindestens zwei Verbindungen der Formel (I) einer der Formeln (II), (III) oder (IV).

Es ist weiterhin bevorzugt für die erfindungsgemäßen Mischungen, dass mindestens eine der mindestens zwei Verbindungen der Formel (I) einer der Formeln (V) bis (IX) entspricht 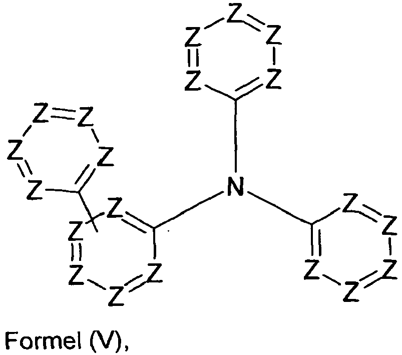 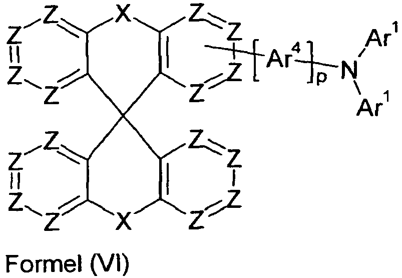 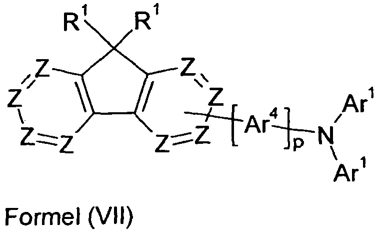 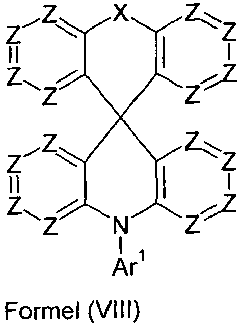 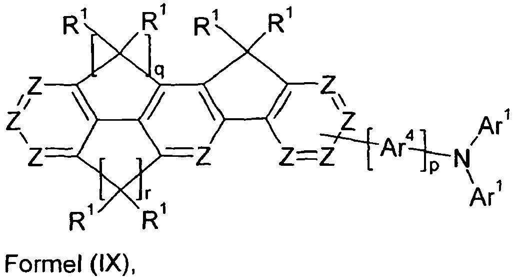 wobei folgendes gilt:
- Z: ist bei jedem Auftreten gleich oder verschieden CR¹ oder N, wobei nicht mehr als zwei benachbarte Gruppen Z für N stehen.
- X: ist bei jedem Auftreten gleich oder verschieden eine Einfachbindung, O, S, Se, BR¹, C(R¹)₂, Si(R¹)₂, NR¹, PR¹, C(R¹)₂-C(R¹)₂, oder CR¹=CR¹;
- Ar¹: ist definiert wie oben;
- Ar⁴: ist bei jeden Auftreten gleich oder verschieden ein aromatisches oder heteroaromatisches Ringsystem mit 5 bis 30 aromatischen Ringatomen, welches durch einen oder mehrere Reste R¹ substituiert sein kann;
- R¹: ist definiert wie oben;
- R²: ist definiert wie oben;
- p: ist gleich 0 oder 1;
- q, r: sind gleich oder verschieden 0 oder 1, wobei die Summe aus q und r gleich 1 oder 2 ist.

Bevorzugt entsprechen zwei der mindestens zwei Verbindungen gemäß Formel (I) einer der oben genannten Formeln (V), (VI), (VII), (VIII) oder (IX).

Es ist besonders bevorzugt für die erfindungsgemäßen Mischungen, dass mindestens eine der mindestens zwei Verbindungen der Formel (I) der Formel (V-1) entspricht 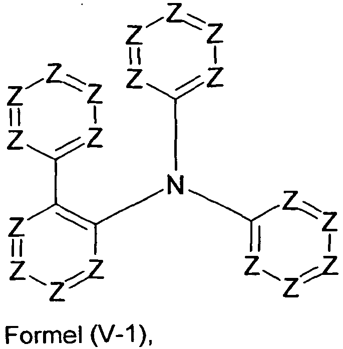 wobei Z bei jedem Auftreten gleich oder verschieden für CR¹ oder N steht, und wobei nicht mehr als zwei benachbarte Gruppen Z für N stehen.

Es ist weiterhin bevorzugt, dass die Gruppe Z betreffend die oben genannten Formeln bei jedem Auftreten gleich oder verschieden CR¹ ist.

Weiterhin bevorzugt ist R¹ bei jedem Auftreten gleich oder verschieden H, D, F, CN, Si(R²)₃, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, wobei die oben genannten Gruppen jeweils mit einem oder mehreren Resten R² substituiert sein können und wobei in den oben genannten Gruppen eine oder mehrere CH₂-Gruppen durch -C=C-, -R²C=CR²-, Si(R²)₂, C=O, C=NR², -NR²-, -O-, -S-, -C(=O)O- oder -C(=O)NR²- ersetzt sein können, oder ein aromatisches oder heteroaromatisches Ringsystem mit 5 bis 20 aromatischen Ringatomen, das jeweils mit einem oder mehreren Resten R² substituiert sein kann, wobei zwei oder mehr Reste R¹ miteinander verknüpft sein können und einen Ring bilden können.

Beispiele für die Verbindungen der Formel (I) sind im Folgenden aufgeführt.

| | | |
|---|---|---|
| 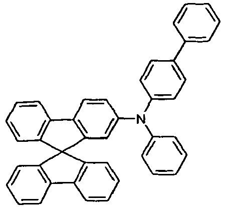 | 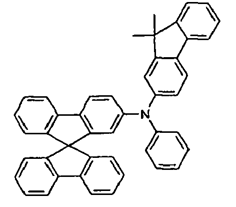 | 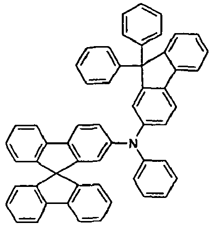 |
| (1) | (2) | (3) |
| 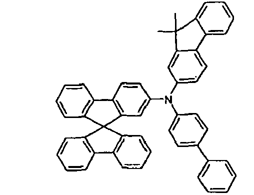 | 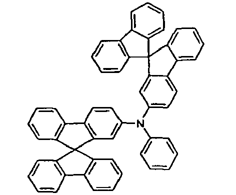 | 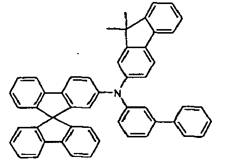 |
| (4) | (5) | (6) |
| 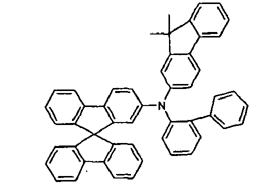 | 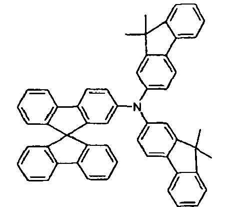 | 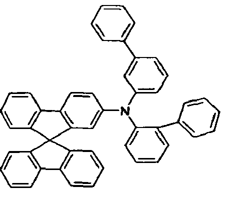 |
| (7) | (8) | (9) |
| 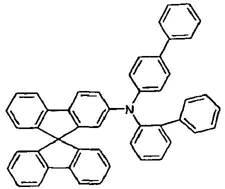 | 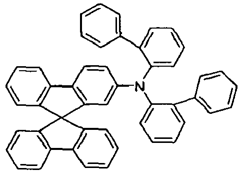 | 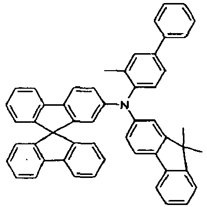 |
| (10) | (11) | (12) |
| 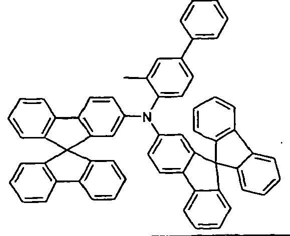 | 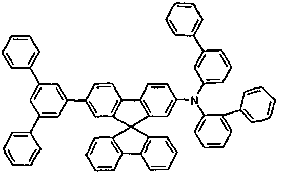 | 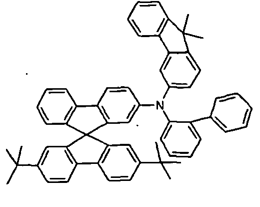 |
| (13) | (14) | (15) |
| 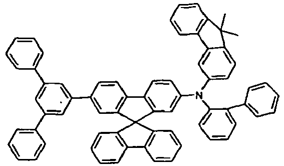 | 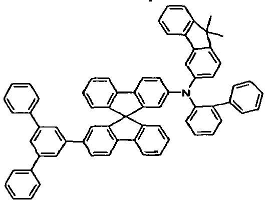 | 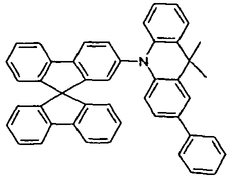 |
| (16) | (17) | (18) |
| 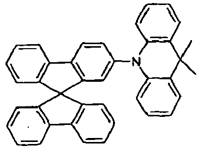 | 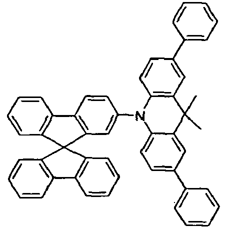 | 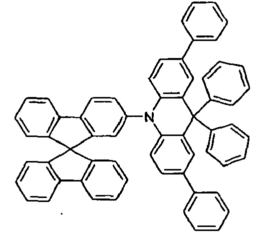 |
| (19) | (20) | (21) |
| 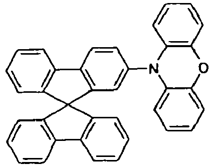 | 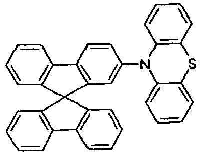 | 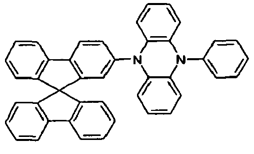 |
| (22) | (23) | (24) |
| 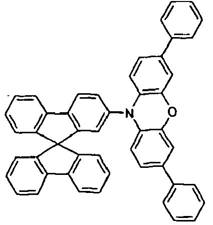 | 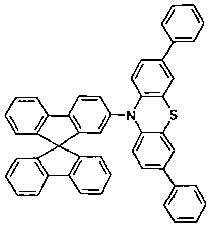 | 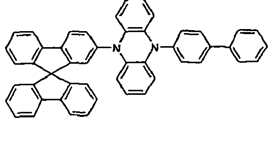 |
| (25) | (26) | (27) |
| 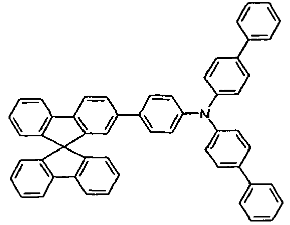 | 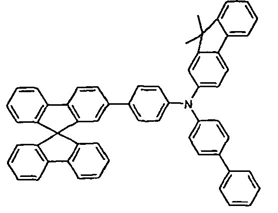 | 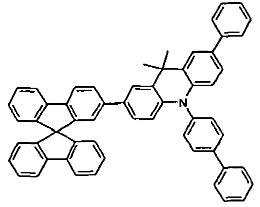 |
| (28) | (29) | (30) |
| 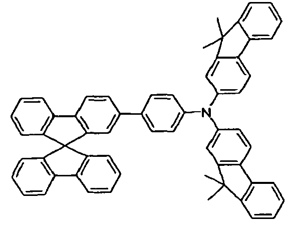 | 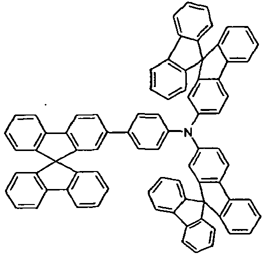 | 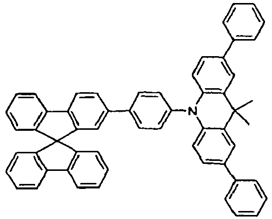 |
| (31) | (32) | (33) |
| 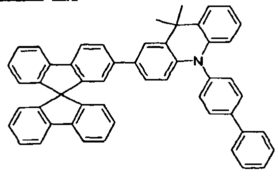 | 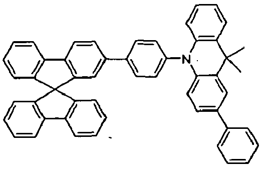 | 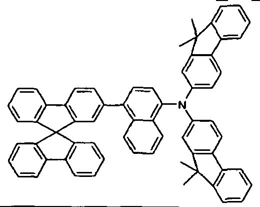 |
| (34) | (35) | (36) |
| 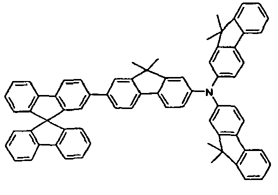 | 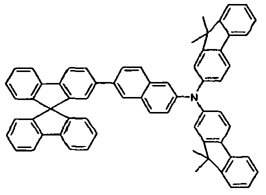 | 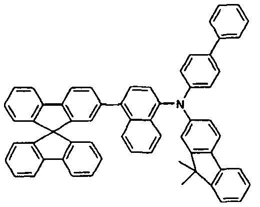 |
| (37) | (38) | (39) |
| 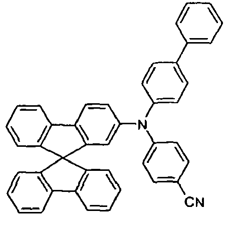 | 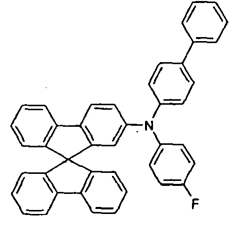 | 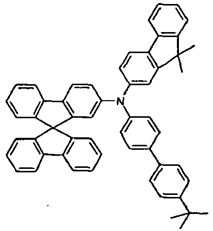 |
| (40) | (41) | (42) |
| 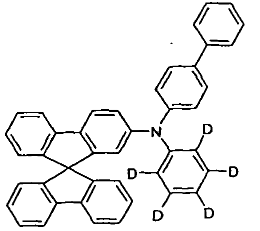 | 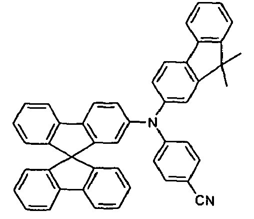 | 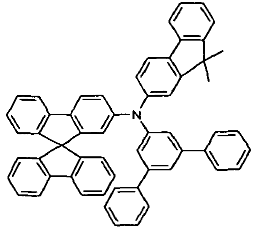 |
| (43) | (44) | (45) |
| 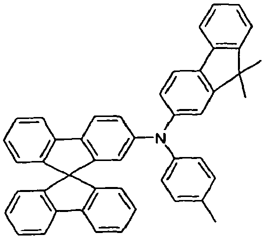 | 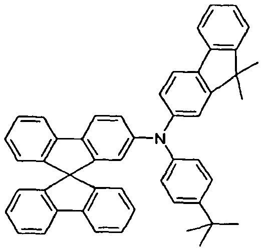 | 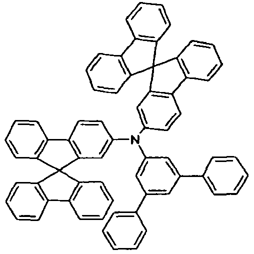 |
| (46) | (47) | (48) |
| 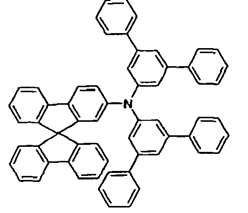 | 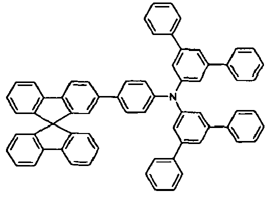 | 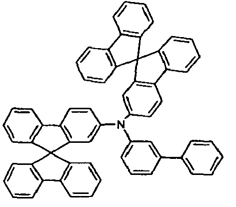 |
| (49) | (50) | (51) |
| 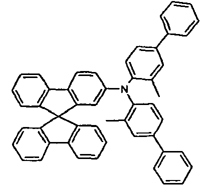 | 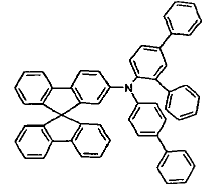 | 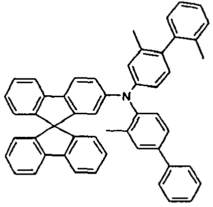 |
| (52) | (53) | (54) |
| 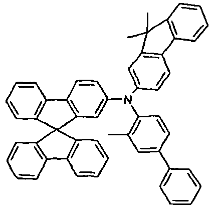 | 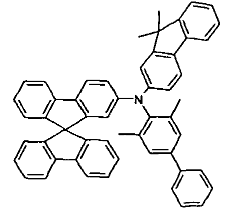 | 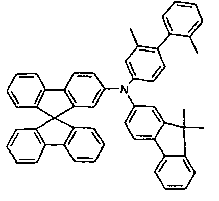 |
| (55) | (56) | (57) |
| 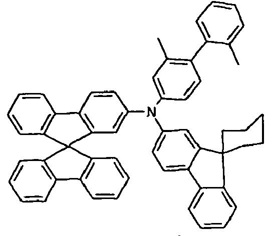 | 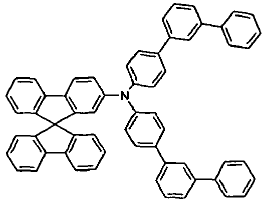 | 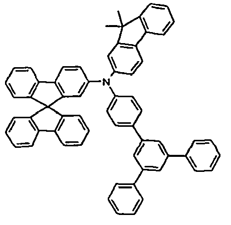 |
| (58) | (59) | (60) |
| 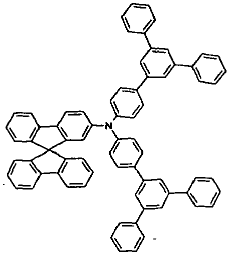 | 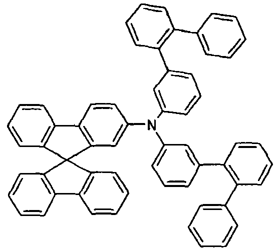 | 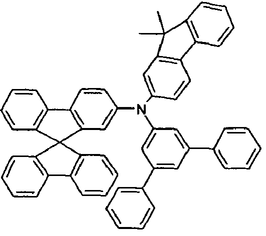 |
| (61) | (62) | (63) |
| 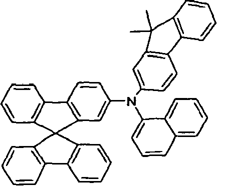 | 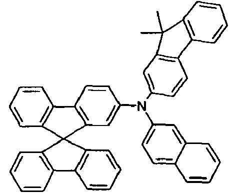 | 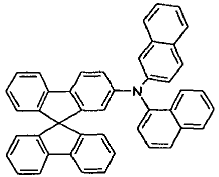 |
| (64) | (65) | (66) |
| 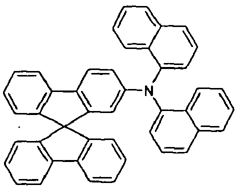 | 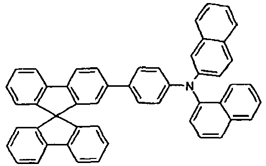 | 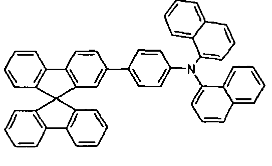 |
| (67) | (68) | (69) |
| 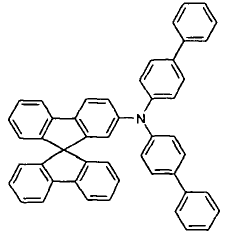 | 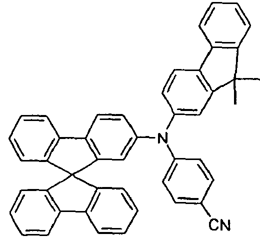 | 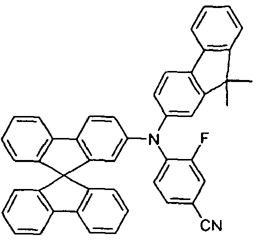 |
| (70) | (71) | (72) |
| 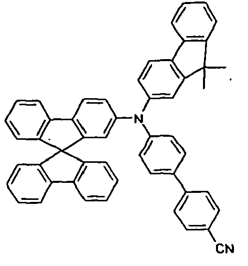 | 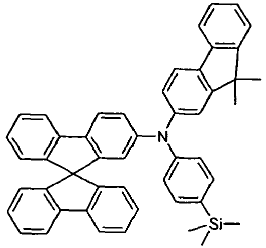 | 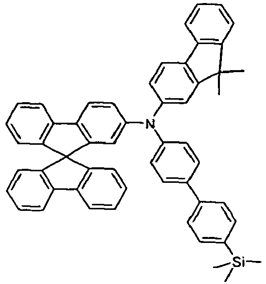 |
| (73) | (74) | (75) |
| 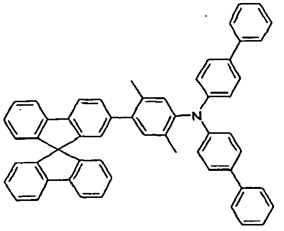 | 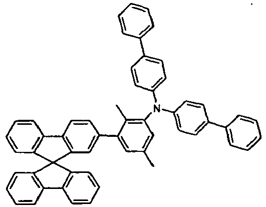 | 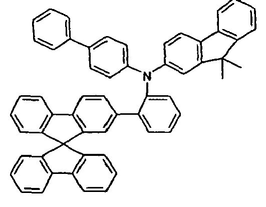 |
| (76) | (77) | (78) |
| 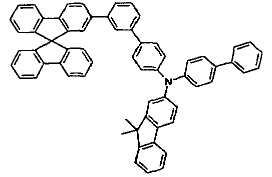 | 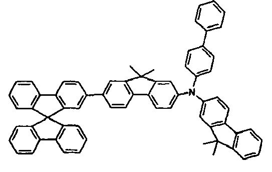 | 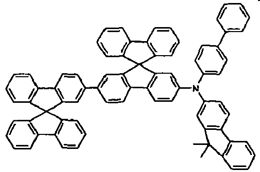 |
| (79) | (80) | (81) |
| 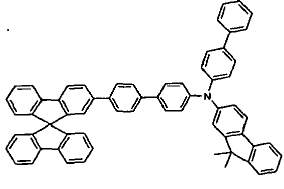 | 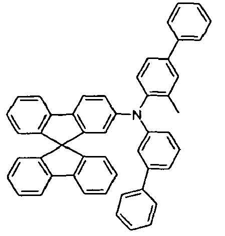 | 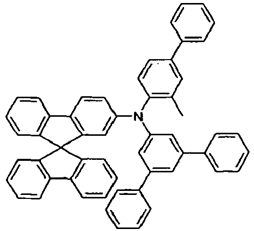 |
| (82) | (83) | (84) |
| 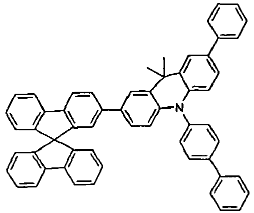 | 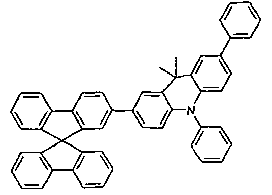 | 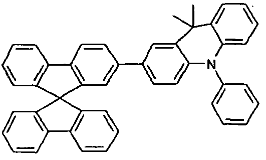 |
| (85) | (86) | (87) |
| 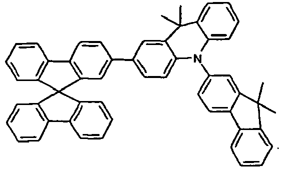 | 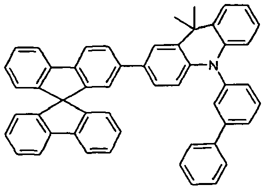 | 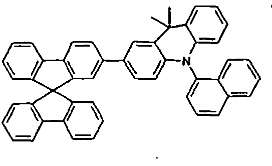 |
| (88) | (89) | (90) |
| 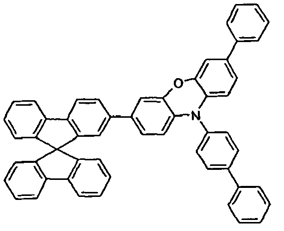 | 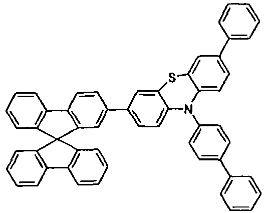 | 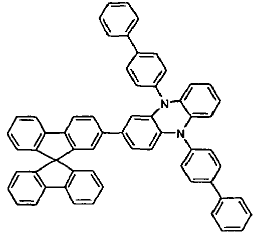 |
| (91) | (92) | (93) |
| 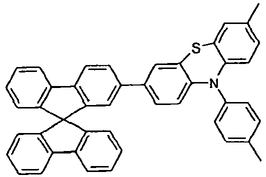 | 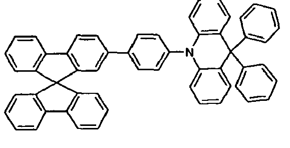 | 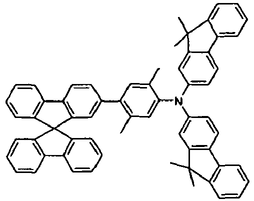 |
| (94) | (95) | (96) |
| 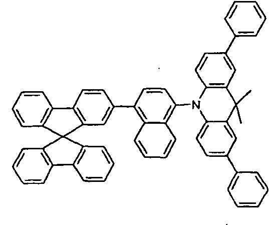 | 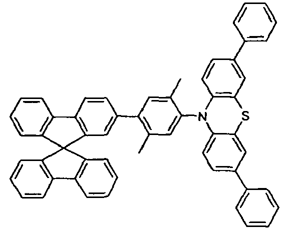 | 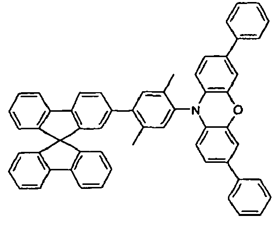 |
| (97) | (98) | (99) |
| 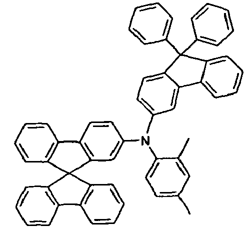 | 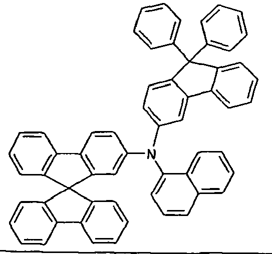 | 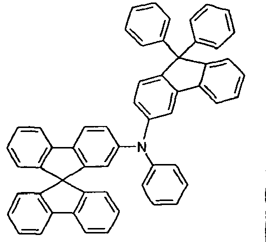 |
| (100) | (101) | (102) |
| 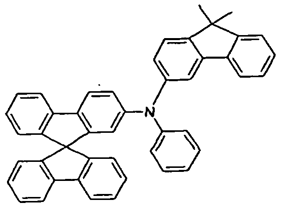 | 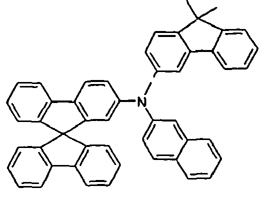 | 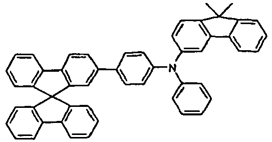 |
| (103) | (104) | (105) |
| 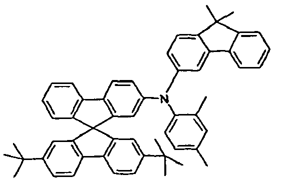 | 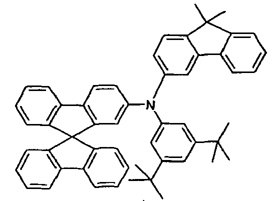 | 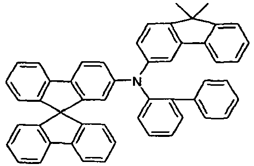 |
| (106) | (107) | (108) |
| 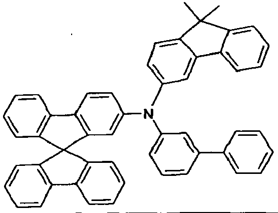 | 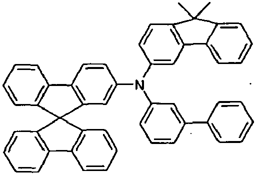 | 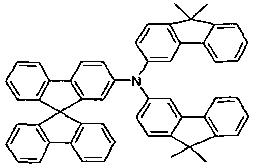 |
| (109) | (110) | (111) |
| 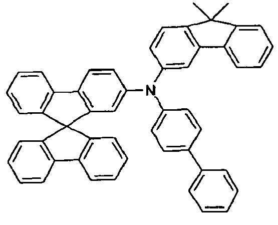 | 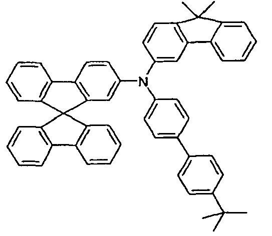 | 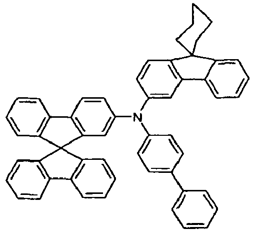 |
| (112) | (113) | (114) |
| 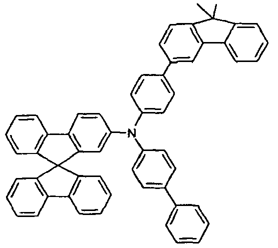 | 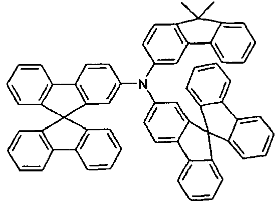 | 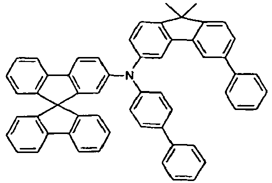 |
| (115) | (116) | (117) |
| 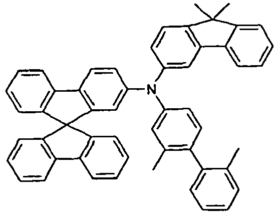 | 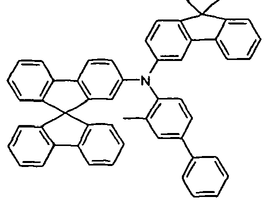 | 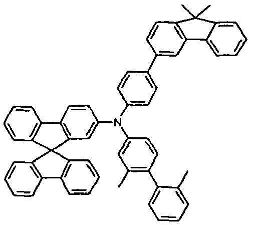 |
| (118) | (119) | (120) |
| 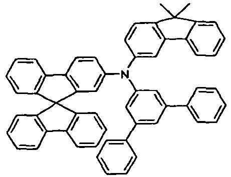 | 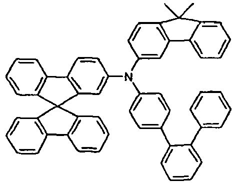 | 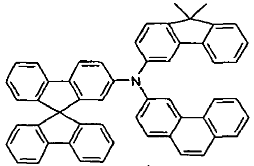 |
| (121) | (122) | (123) |
| 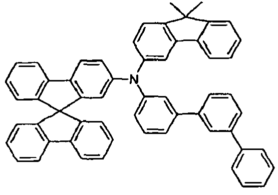 | 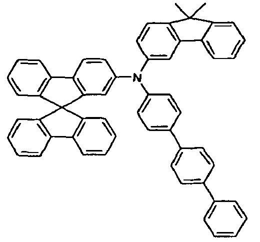 | 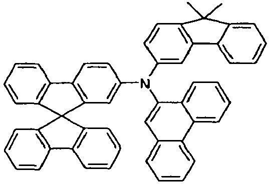 |
| (124) | (125) | (126) |
| 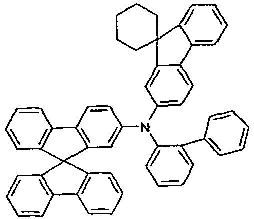 | 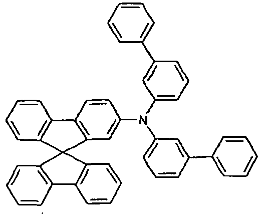 | 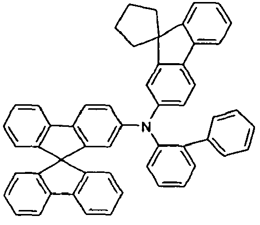 |
| (127) | (128) | (129) |
| 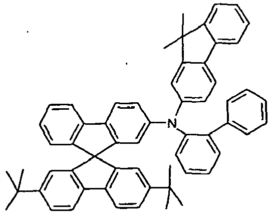 | 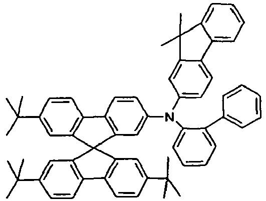 | 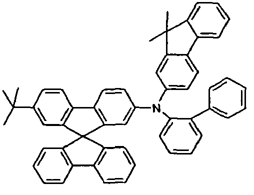 |
| (130) | (131) | (132) |
| 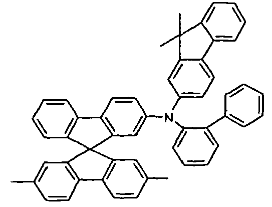 | 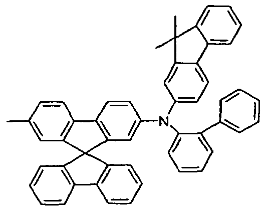 | 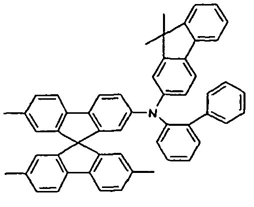 |
| (133) | (134) | (135) |
| 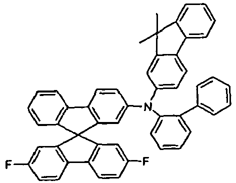 | 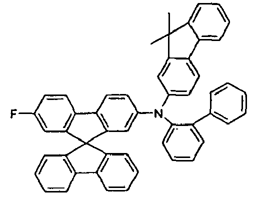 | 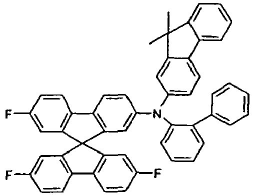 |
| (136) | (137) | (138) |
| 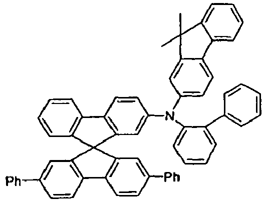 | 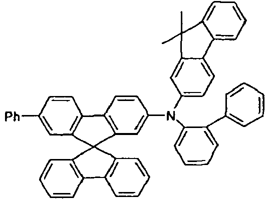 | 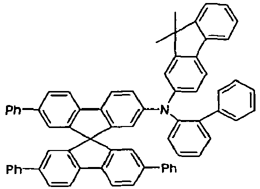 |
| (139) | (140) | (141) |
| 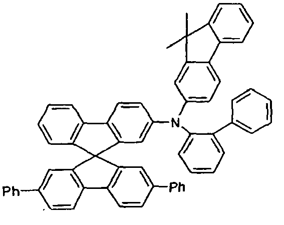 | 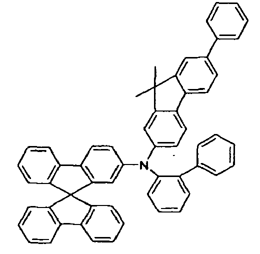 | 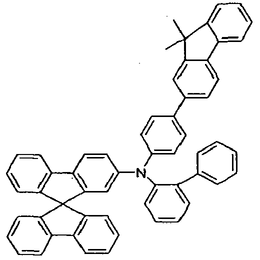 |
| (142) | (143) | (144) |
| 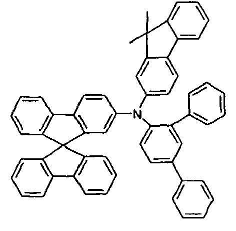 | 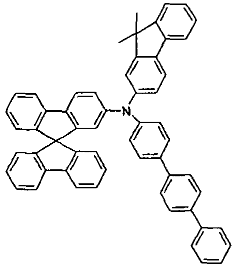 | 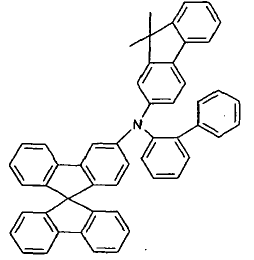 |
| (145) | (146) | (147) |
| 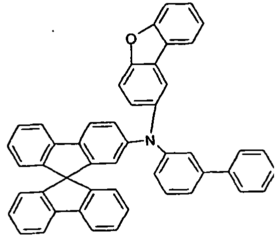 | 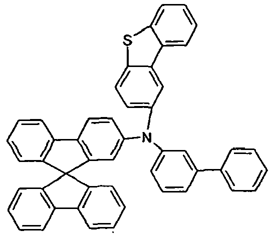 | 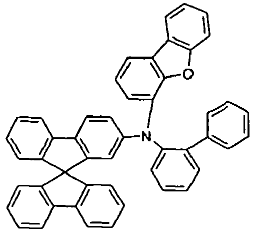 |
| (148) | (149) | (150) |
| 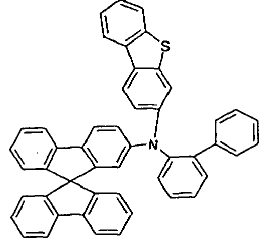 | 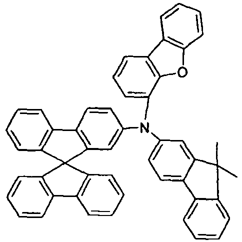 | 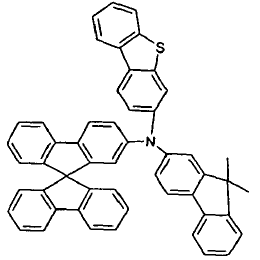 |
| (151) | (152) | (153) |
| 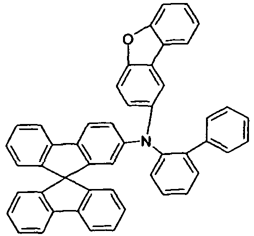 | 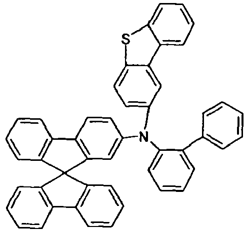 | 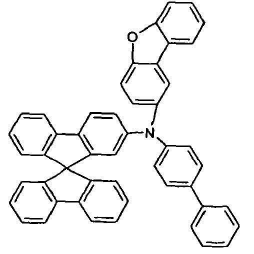 |
| (154) | (155) | (156) |
| 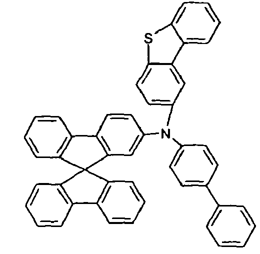 | 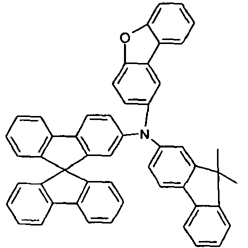 | 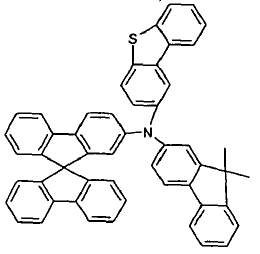 |
| (157) | (158) | (159) |
| 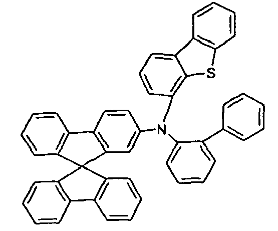 | 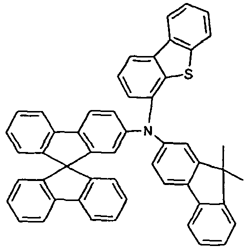 | 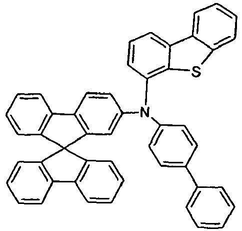 |
| (160) | (161) | (162) |
| 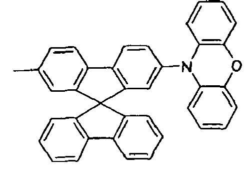 | 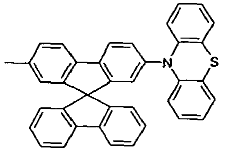 | 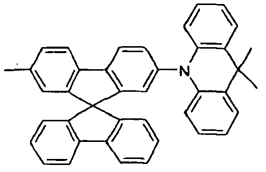 |
| (163) | (164) | (165) |
| 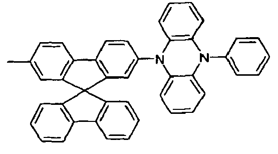 | 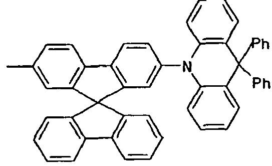 | 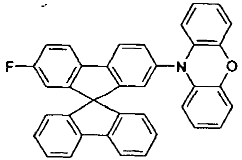 |
| (166) | (167) | (168) |
| 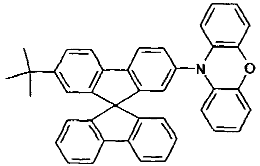 | 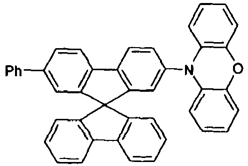 | 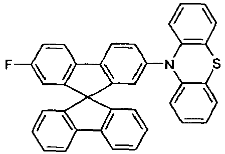 |
| (169) | (170) | (171) |
| 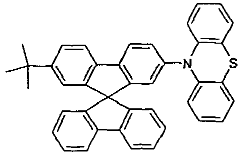 | 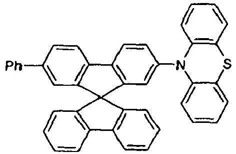 | 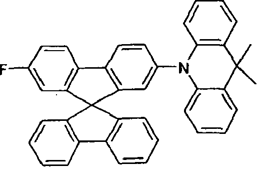 |
| (172) | (173) | 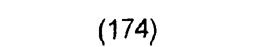 |
| 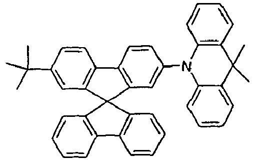 | 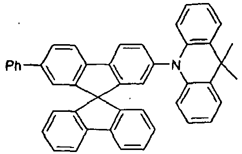 | 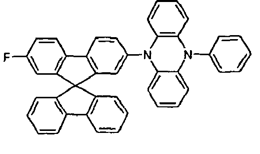 |
| (175) | (176) | (177) |
| 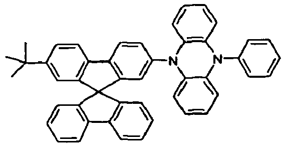 | 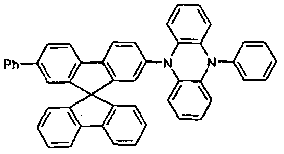 | 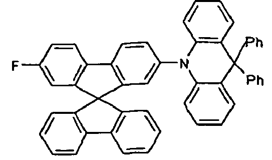 |
| (178) | (179) | (180) |
| 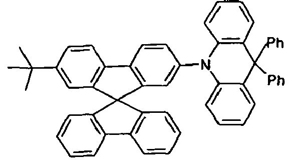 | 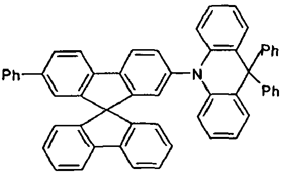 | 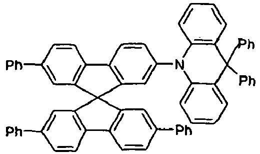 |
| (181) | (182) | (183) |
| 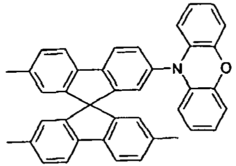 | 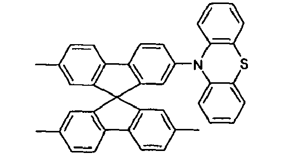 | 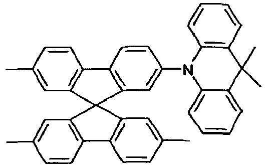 |
| (184) | (185) | (186) |
| 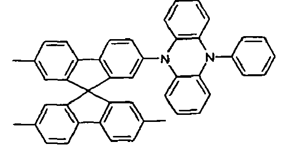 | 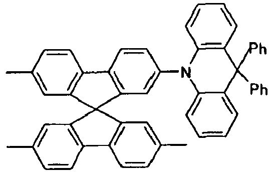 | 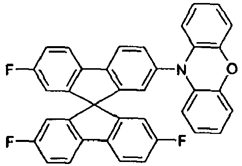 |
| (187) | (188) | (189) |
| 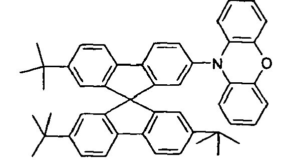 | 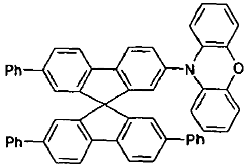 | 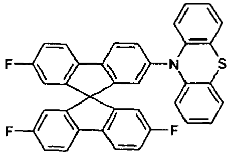 |
| (190) | (191) | (192) |
| 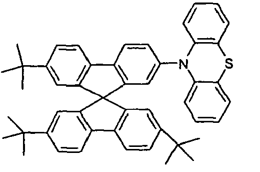 | 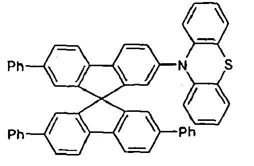 | 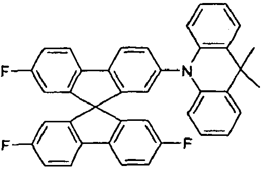 |
| (193) | (194) | (195) |
| 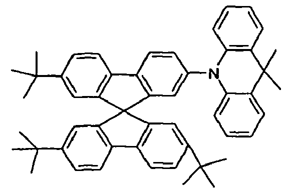 | 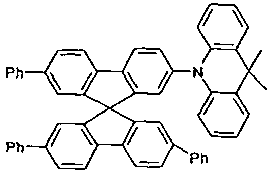 | 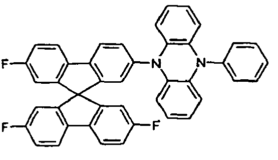 |
| (196) | (197) | (198) |
| 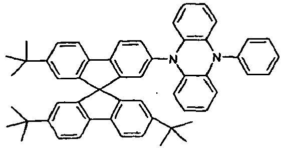 | 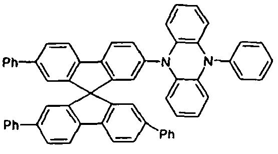 | 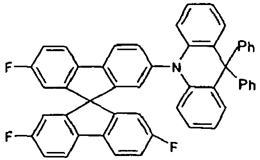 |
| (199) | (200) | (201) |
| 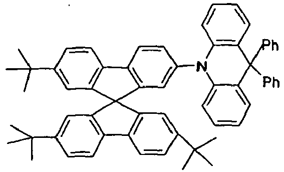 | 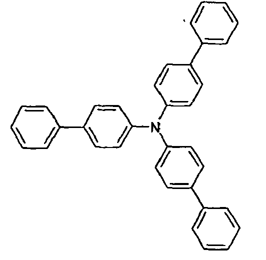 | 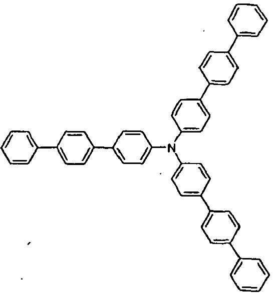 |
| (202) | (203) | (204) |
| 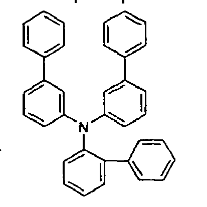 | 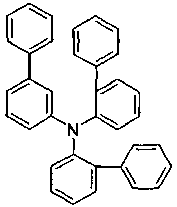 | 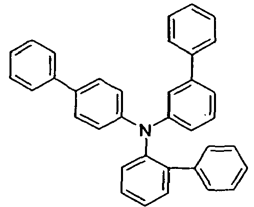 |
| (205) | (206) | (207) |
| 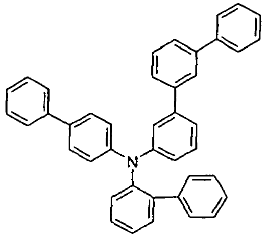 | 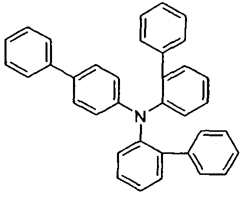 | 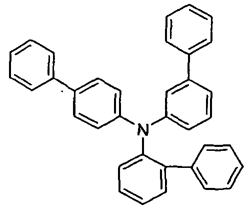 |
| (208) | (209) | (210) |
| 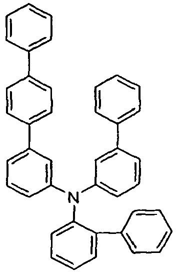 | 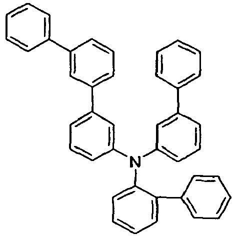 | 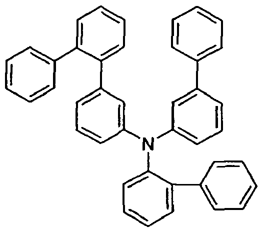 |
| (211) | (212) | (213) |
| 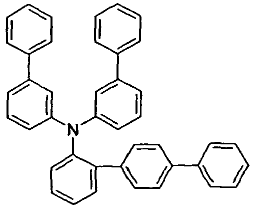 | 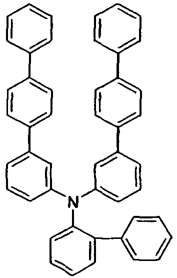 | 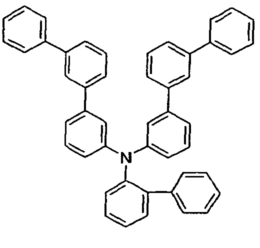 |
| (214) | (215) | (216) |
| 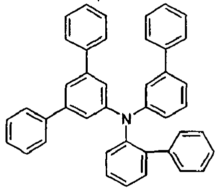 | 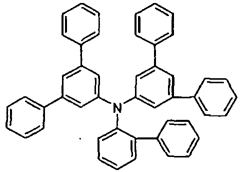 | 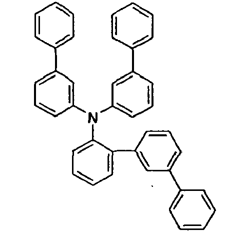 |
| (217) | (218) | (219) |
| 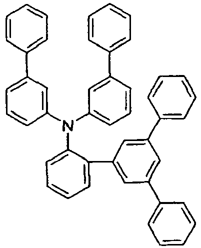 | 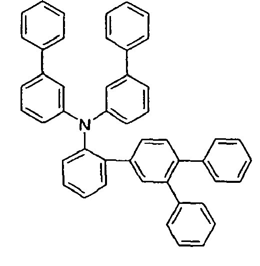 | 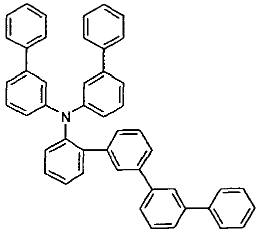 |
| (220) | (221) | (222) |
| 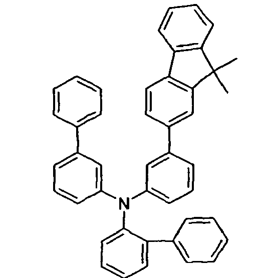 | 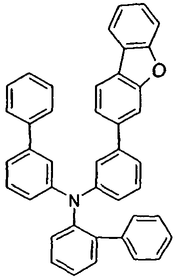 | 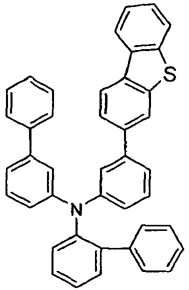 |
| (223) | (224) | (225) |
| 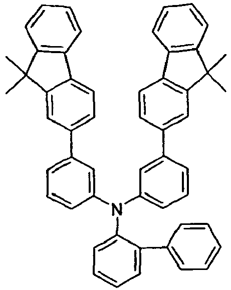 | 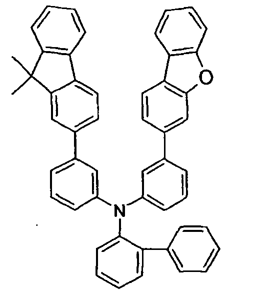 | 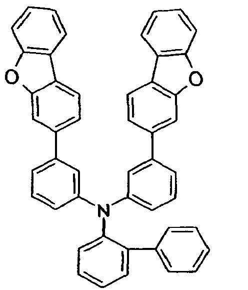 |
| (226) | (227) | (228) |
| 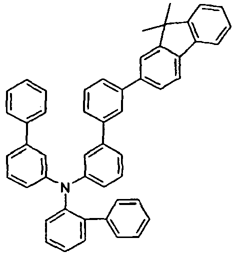 | 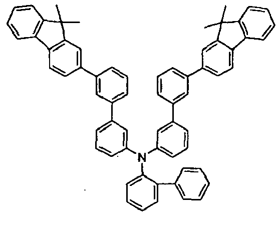 | 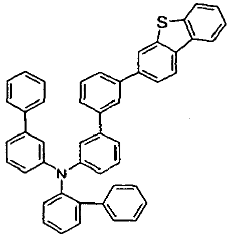 |
| (229) | (230) | (231) |
| 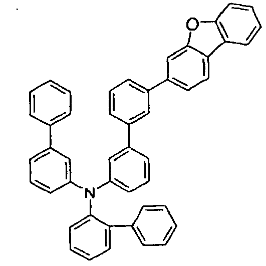 | 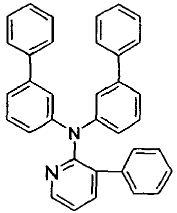 | 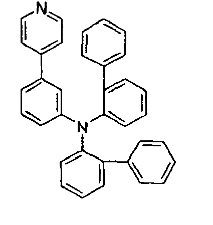 |
| (232) | (233) | (234) |
| 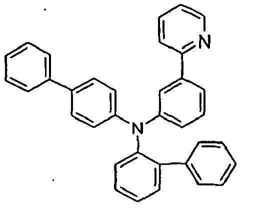 | 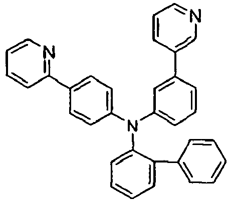 | 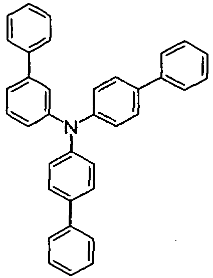 |
| (235) | (236) | (237) |
| 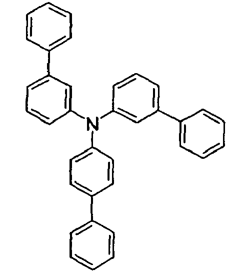 | 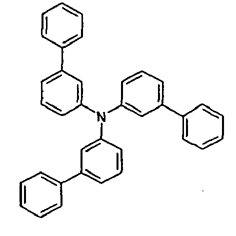 | 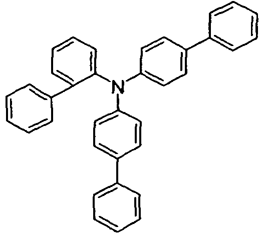 |
| (238) | (239) | (240) |
| 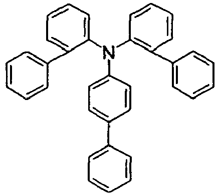 | 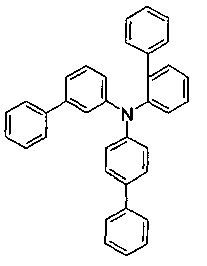 | 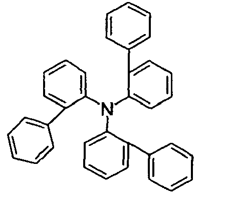 |
| (241) | (242) | (243) |
| 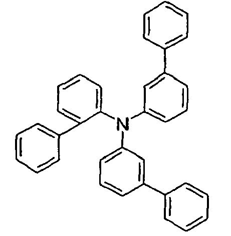 | 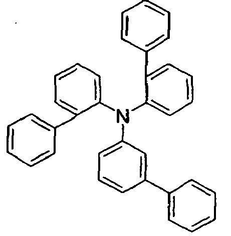 | 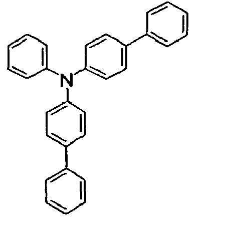 |
| (244) | (245) | (246) |
| 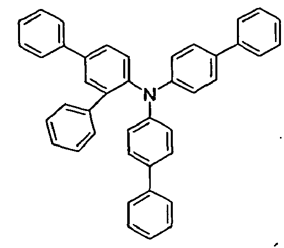 | 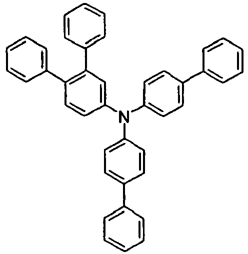 | 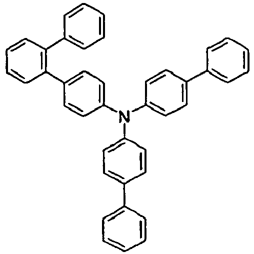 |
| (247) | (248) | (249) |
| 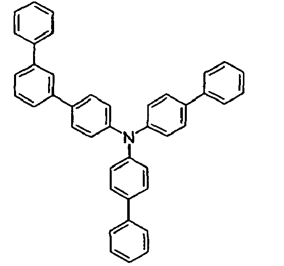 | 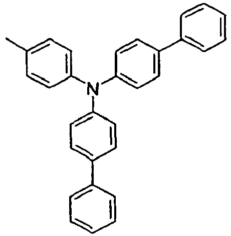 | 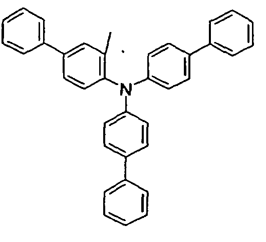 |
| (250) | (251) | (252) |
| 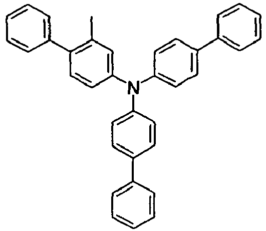 | 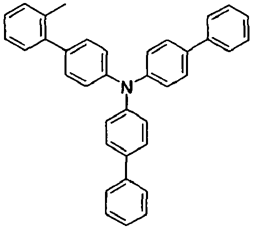 | 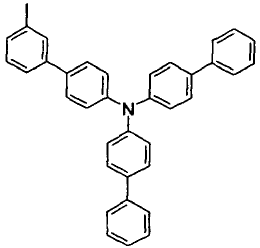 |
| (253) | (254) | (255) |

Weitere Beispiele für Ausführungsformen der mindestens zwei Verbindungen gemäß Formel (I) sind in den Anmeldungen EP 12005369.9 (noch nicht offengelegt, Fluoren-Monoamine), EP 12005370.7 (noch nicht offengelegt, Fluoren-Monoamine), EP 12005371.5 (noch nicht offengelegt, Fluoren-Monoamine), EP 12000929.5 (noch nicht offengelegt, Spirobifluoren-Monoamine), EP 11009779.7 (noch nicht offengelegt, Trisbiphenyl-Amine), EP 11009127.9 (noch nicht offengelegt, Spiro-Benzopyran-Amine), WO 2012/150001 (Aryl-substituierte Dihydroacridine), WO 2012/034627 (Spirobifluoren-Monoamine), JP 1995/053955 (Tris-Biphenylamine), WO 2006/123667 (Tris-Biphenylamine) und JP 2010/222268 (Tris-Biphenylamine) in den entsprechenden Ausführungsbeispielen und in den Tabellenbeispielen offenbart.

Verfahren zur Herstellung der Verbindungen gemäß Formel (I) sind dem Fachmann bekannt. Verfahren zur Herstellung der bevorzugten Verbindungen gemäß Formel (V-1) sind in der noch nicht offengelegten Anmeldung EP 11009779.7 beschrieben.

Die erfindungsgemäße Mischung wird durch Mischen der enthaltenen Verbindungen, insbesondere der mindestens zwei Verbindungen gemäß Formel (I), hergestellt. Die Mischung kann unterschiedlich weiterverarbeitet werden.

Für die Verarbeitung der erfindungsgemäßen Mischung aus flüssiger Phase, beispielsweise durch Spin-Coating oder durch Druckverfahren, sind Formulierungen der erfindungsgemäßen Mischung erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Dimethylanisol, Mesitylen, Tetralin, Veratrol, THF, Methyl-THF, THP, Chlorbenzol, Dioxan oder Mischungen dieser Lösemittel. Es ist bevorzugt, dass die Formulierung enthaltend die erfindungsgemäße Mischung ein oder mehrere Polymere, Oligomere oder Dendrimere enthält. Die Polymere, Oligomere oder Dendrimere sind bevorzugt in einer Konzentration von 1-80 %, besonders bevorzugt 5-65 % und ganz besonders bevorzugt 10-50 % in der Formulierung enthalten. Sie dienen insbesondere zum Einstellen der Eigenschaften der Formulierung, beispielsweise der Viskosität. Bevorzugt ist die Verwendung von Polyarylaminen, Polystyrolen, Polyacrylaten und Polyestern, insbesondere die Verwendung der in der WO 2011/076325 offenbarten Polymere.

Weiterer Gegenstand der Erfindung ist somit eine Formulierung, insbesondere eine Lösung, Dispersion oder Emulsion, enthaltend die erfindungsgemäße Mischung sowie mindestens ein Lösungsmittel, bevorzugt ein organisches Lösungsmittel. Wie solche Lösungen hergestellt werden können, ist dem Fachmann bekannt und beispielsweise in WO 2002/072714, WO 2003/019694 und der darin zitierten Literatur beschrieben.

Die erfindungsgemäße Mischung eignet sich für den Einsatz in elektronischen Vorrichtungen, insbesondere in organischen Elektrolumineszenzvorrichtungen (OLEDs).

Weitere Gegenstände der Erfindung sind daher die Verwendung der erfindungsgemäßen Mischung in elektronischen Vorrichtungen sowie eine elektronische Vorrichtung, enthaltend die erfindungsgemäße Mischung in einer organischen Schicht.

Dabei ist die elektronische Vorrichtung bevorzugt ausgewählt aus der Gruppe bestehend aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und besonders bevorzugt organischen Elektrolumineszenzvorrichtungen (OLEDs).

Besonders bevorzugt ist eine organische Elektrolumineszenzvorrichtung, enthaltend Anode, Kathode und mindestens eine emittierende Schicht, dadurch gekennzeichnet, dass mindestens eine organische Schicht der Vorrichtung mindestens eine erfindungsgemäße Mischung enthält.

Außer Kathode, Anode und der emittierenden Schicht kann die organische Elektrolumineszenzvorrichtung noch weitere Schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronen-blockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*)* und/oder organischen oder anorganischen p/n-Übergängen. Es sei aber darauf hingewiesen, dass nicht notwendigerweise jede dieser Schichten vorhanden sein muss und die Wahl der Schichten sowohl von den verwendeten Verbindungen abhängt als auch davon, ob es sich um eine fluoreszierende oder phosphoreszierende Elektrolumineszenzvorrichtung handelt.

Die Abfolge der Schichten der erfindungsgemäßen organischen Elektrolumineszenzvorrichtung ist bevorzugt die folgende: Anode-Lochinjektionsschicht-Lochtransportschicht-Elektronenblockierschicht-emittierende Schicht-Elektronentransportschicht-Elektroneninjektionsschicht-Kathode. Dabei müssen nicht alle der genannten Schichten vorhanden sein, es können zusätzlich weitere Schichten vorhanden sein, und es können einzelne Funktionsschichten mehrfach vorkommen.

Besonders bevorzugt ist folgende Abfolge der Schichten der organischen Elektrolumineszenzvorrichtung:
Anode-Lochinjektionsschicht 1-Lochinjektionsschicht 2-Lochinjektionsschicht 3-Lochtransportschicht-Elektronenblockierschichtemittierende Schicht-Elektronentransportschicht-Kathode.
Dabei müssen nicht alle der genannten Schichten vorhanden sein, es können zusätzlich weitere Schichten vorhanden sein, und es können einzelne Funktionsschichten mehrfach vorkommen.

Die erfindungsgemäße organische Elektrolumineszenzvorrichtung kann mehrere emittierende Schichten enthalten. Besonders bevorzugt weisen diese Emissionsschichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues oder gelbes oder orangefarbenes oder rotes Licht emittieren. Insbesondere bevorzugt sind Dreischichtsysteme, also Systeme mit drei emittierenden Schichten, wobei die drei Schichten blaue, grüne und orange oder rote Emission zeigen (für den prinzipiellen Aufbau siehe z. B. WO 2005/011013). Für die Erzeugung von weißem Licht kann sich anstelle mehrerer farbig emittierender Emitterverbindungen auch eine einzelne Emitterverbindung eignen, die in einem breiten Wellenlängenbereich emittiert.

Es ist bevorzugt, dass die erfindungsgemäße Mischung in einer Schicht mit lochtransportierender Funktion verwendet wird. Besonders bevorzugt ist dies eine Lochinjektionsschicht, eine Lochtransportschicht, oder eine Elektronenblockierschicht. Ganz besonders bevorzugt ist die Verwendung in einer Lochtransportschicht oder einer Elektronenblockierschicht, am stärksten bevorzugt in einer Elektronenblockierschicht.

Im Sinne der vorliegenden Anmeldung umfasst der Begriff Lochtransportschicht alle organischen Schichten, die sich zwischen Anode und emittierender Schicht befinden, das heißt insbesondere Lochinjektionsschichten, Lochtransportschichten, Elektronenblockierschichten und Zwischenschichten (Interlayer). Unter einer Lochinjektionsschicht wird im Sinne der vorliegenden Anmeldung eine organische Schicht verstanden, welche sich direkt an die Anode anschließt oder durch eine einzelne Beschichtung der Anode von ihr getrennt ist. Unter einer Elektronenblockierschicht wird eine organische Schicht verstanden, welche sich direkt anodenseitig an die emittierende Schicht anschließt.

Die Schicht enthaltend die erfindungsgemäße Mischung kann eine p-dotierte Schicht sein. Es gelten die im Zusammenhang mit der erfindungsgemäßen Mischung angegebenen bevorzugten Ausführungsformen der p-Dotierung und der p-Dotanden.

Bevorzugt grenzt die Schicht enthaltend die erfindungsgemäße Mischung direkt anodenseitig an die emittierende Schicht an.

Gemäß einer weiteren bevorzugten Ausführungsform enthält die organische Elektrolumineszenzvorrichtung zusätzlich mindestens eine weitere lochtransportierende Schicht, die anodenseitig von der Schicht enthaltend die erfindungsgemäße Mischung angeordnet ist.

Bevorzugt grenzt diese weitere lochtransportierende Schicht direkt an die Schicht enthaltend die erfindungsgemäße Mischung an.

Bevorzugt enthält die weitere lochtransportierende Schicht mindestens ein Mono-Triarylamin. Besonders bevorzugt enthält die weitere lochtransportierende Schicht mindestens eine Verbindung gemäß Formel (I). Es gelten auch für die Verbindung gemäß Formel (I) der weiteren lochtransportierenden Schicht die oben angegebenen bevorzugten Ausführungsformen von Formel (I). Weiterhin ist es bevorzugt, dass die Verbindung gemäß Formel (I) in der weiteren lochtransportierenden Schicht als Reinsubstanz vorliegt, mit bevorzugt weniger als 10 % anderen Verbindungen in der Schicht, besonders bevorzugt weniger als 5 % anderen Verbindungen in der Schicht, ganz besonders bevorzugt weniger als 1 % anderen Verbindungen in der Schicht.

Unter einem Mono-Triarylamin wird eine Verbindung verstanden, welche eine einzige Triarylamingruppe aufweist. Eine Triarylamingruppe ist eine Gruppe, in der drei Aryl- oder Heteroarylgruppen an ein gemeinsames Stickstoffatom gebunden sind. Bevorzugt enthält das Mono-Triarylamin keine weitere Arylaminogruppe. Besonders bevorzugt enthält das Mono-Triarylamin keine weitere Aminogruppe.

Gemäß einer weiteren bevorzugten Ausführungsform wird die erfindungsgemäße Mischung als Hostmaterial in einer emittierenden Schicht der organischen Elektrolumineszenzvorrichtung verwendet. Dabei kann die emittierende Schicht eine fluoreszierende oder eine phosphoreszierende Schicht sein. Bevorzugt sind in diesem Fall neben der erfindungsgemäßen Mischung und der Emitterverbindung eine oder mehrere weitere Hostverbindungen vorhanden.

Gemäß einer weiteren bevorzugten Ausführungsform wird die erfindungsgemäße Mischung in einer Auskoppelschicht der elektronischen Vorrichtung verwendet. Eine Auskoppelschicht ist eine Schicht, welche sich auf der Kathode befindet, auf der der Anode abgewandten Seite. Sie wird insbesondere bei Top-Emission-Vorrichtungen, das heißt Vorrichtungen, bei denen durch die Kathode Licht emittiert wird, verwendet.

Im Folgenden sind bevorzugte Ausführungsformen der Materialien offenbart, die in den entsprechenden Funktionsschichten der erfindungsgemäßen Vorrichtung verwendet werden.

Vom Begriff phosphoreszierende Emitter (=Dotanden) sind typischerweise Verbindungen umfasst, bei denen die Lichtemission durch einen spinverbotenen Übergang erfolgt, beispielsweise einen Übergang aus einem angeregten Triplettzustand oder einem Zustand mit einer höheren Spinquantenzahl, beispielsweise einem Quintett-Zustand.

Als phosphoreszierende Dotanden eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende Dotanden Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Dabei werden im Sinne der vorliegenden Erfindung alle lumineszierenden Iridium-, Platin- oder Kupferkomplexe als phosphoreszierende Verbindungen angesehen.

Beispiele der oben beschriebenen phosphoreszierenden Dotanden können den Anmeldungen WO 2000/70655, WO 2001/41512, WO 2002/02714, WO 2002/15645, EP 1191613, EP 1191612, EP 1191614, WO 2005/033244, WO 2005/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind, zur Verwendung in den erfindungsgemäßen Vorrichtungen. Auch kann der Fachmann ohne erfinderisches Zutun weitere phosphoreszierende Komplexe in Kombination mit den erfindungsgemäßen Verbindungen in OLEDs einsetzen.

Bevorzugte fluoreszierende Dotanden sind ausgewählt aus der Klasse der Arylamine. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind.

Als Matrixmaterialien, bevorzugt für fluoreszierende Dotanden, kommen neben den erfindungsgemäßen Mischungen Materialien verschiedener Stoffklassen in Frage. Bevorzugte Matrixmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052) oder der Benzanthracene (z. B. gemäß WO 2008/145239). Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind.

Bevorzugte Matrixmaterialien für phosphoreszierende Dotanden sind neben den erfindungsgemäßen Mischungen aromatische Amine, insbesondere Triarylamine, z. B. gemäß US 2005/0069729, Carbazolderivate (z. B. CBP, N,N-Biscarbazolylbiphenyl) oder Verbindungen gemäß WO 2005/039246, US 2005/0069729, JP 2004/288381, EP 1205527 oder WO 2008/086851, verbrückte Carbazolderivate, z. B. gemäß WO 2011/088877 und WO 2011/128017, Indenocarbazolderivate, z. B. gemäß WO 2010/136109 und WO 2011/000455, Azacarbazolderivate, z. B. gemäß EP 1617710, EP 1617711, EP 1731584, JP 2005/347160, Indolocarbazolderivate, z. B. gemäß WO 2007/063754 oder WO 2008/056746, Ketone, z. B. gemäß WO 2004/093207 oder WO 2010/006680, Phosphinoxide, Sulfoxide und Sulfone, z. B. gemäß WO 2005/003253, Oligophenylene, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Aluminiumkomplexe, z. B. BAlq, Diazasilol- und Tetraazasilol-Derivate, z. B. gemäß WO 2010/054729, Diazaphosphol-Derivate, z. B. gemäß WO 2010/054730 und Aluminiumkomplexe, z. B. BAlQ.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind neben den erfindungsgemäßen Mischungen beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Beispiele für bevorzugte Lochtransportmaterialien, die in einer Lochtransport-, Lochinjektions- oder Elektronenblockierschicht in der erfindungsgemäßen Elektrolumineszenzvorrichtung verwendet werden können, wurden bereits oben offenbart.

Als Kathode der organischen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

In einer bevorzugten Ausführungsform ist die erfindungsgemäße organische Elektrolumineszenzvorrichtung dadurch gekennzeichnet, dass eine oder mehrere Schichten, insbesondere die Schicht enthaltend die erfindungsgemäße Mischung, mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Dabei ist es jedoch auch möglich, dass der Anfangsdruck noch geringer ist, beispielsweise kleiner 10⁻⁷ mbar.

Das Aufbringen der erfindungsgemäßen Mischung kann zum Einen durch Verdampfen der Mischung erfolgen. Zum Anderen kann die Mischung in situ durch Co-Verdampfen der verschiedenen Mischungskomponenten hergestellt werden.

Bevorzugt ist ebenfalls eine organische Elektrolumineszenzvorrichtung, dadurch gekennzeichnet, dass eine oder mehrere Schichten, insbesondere die Schicht enthaltend die erfindungsgemäße Mischung, mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden.

Weiterhin bevorzugt ist es, dass zur Herstellung der erfindungsgemäßen organischen Elektrolumineszenzvorrichtung eine oder mehrere Schichten aus Lösung und eine oder mehrere Schichten durch ein Sublimationsverfahren aufgetragen werden.

Die erfindungsgemäße elektronische Vorrichtung kann in Displays, als Lichtquelle in Beleuchtungsanwendungen sowie als Lichtquelle in medizinischen und/oder kosmetischen Anwendungen (z.B. Lichttherapie) eingesetzt werden.

### Ausführungsbeispiele

### Beispiel 1: DSC-Untersuchungen

### Verwendete Materialien: Siehe Tabelle 6

Die Materialmischungen werden durch Einwiegen von je 1 g der Einzelmaterialien HTM1 bis 6 (Reinheit jeweils > 99.95 % ig. nach HPLC, zweimal sublimiert) in eine Ampulle, evakuieren (Basisdruck ca. 10⁻⁶ mbar) und Abschmelzen der Ampulle unter Vakuum, Aufschmelzen des Ampulleninhalts und Abkühlen auf Raumtemperatur, in Form von durchsichtigen organischen Gläsern erhalten.

| **Material bzw. Materialmischung** | **Mischungszusammensetrung (Masse %)** | **Tg /° C** | **Tm /° C** |
|---|---|---|---|
| HTM1 | 100% | 136 | 257 |
| HTM2 | 100% | 59 | n.b. |
| HTM3 | 100% | 67 | 194 |
| HTM4 | 100% | 63 | 224 |
| HTM5 | 100% | 148 | n.b. |
| HTM6 | 100% | 143 | 301 |
| M1 | HTM2 (50%) / HTM3 (50%) | 62 | n.b. |
| M2 | HTM1 (50%) / HTM5 (50%) | 139 | n.b. |
| M3 | HTM1 (50%) / HTM2 (50%) | 79 | n.b. |
| M4 | HTM2 (33.3 %) / HTM3 (33.3%) / HTM4 (33.3%) | 64 | n.b. |
| M5 | HTM1 (33.3 %) / HTM2 (33.3%) / HTM5 (33.3%) | 75 | n.b. |
| M6 | HTM1 (33.3 %) / HTM15 (33.3%) / HTM6 (33.3%) | 139 | n.b. |
| M7 | HTM3 (50%) / HTM4 (50%) | 65 | n.b. |
| M8 | HTM5 (50%) / HTM6 (50%) | 145 | n.b. |
| M9 | HTM2 (50%) / HTM4 (50%) | 62 | n.b. |

| | | | |
|---|---|---|---|
| n.b.: nicht beobachtet | | | |

Die DSC-Messungen werden an einem TA-Instruments Q 2000 Serie durchgeführt. Der Temperaturbereich für den ersten und zweiten Heiz-Kühl-Zyklus beträgt 0 bis 290 °C bei einer Heiz- bzw. Kühlrate von 20 K/min.

Bei den Mischungen M1 bis M9 wird bei mehreren Heiz- und Kühlzyklen beim Heizen über Tg hinaus kein Kristallisieren, beim entsprechend folgenden Kühlen kein Rekristallisieren beobachtet. Sie bleiben also beständig glasförmig.

Bei den Einzelverbindungen HTM1, HTM3, HTM4 und HTM6 hingegen wird beim Heizen über Tg hinaus Kristallisieren, anschließend Schmelzen und beim folgenden Kühlen Rekristallisieren beobachtet.

### Beispiel 2: Herstellung der OLEDs und allgemeine Device-Daten

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, Materialien) angepasst wird.

In den folgenden Beispielen (siehe Tabellen 1 bis 4) werden die Daten verschiedener OLEDs vorgestellt. Glasplättchen, die mit strukturiertem ITO (Indium Zinn Oxid) der Dicke 50 nm beschichtet sind werden verwendet. Diese beschichteten Glasplättchen bilden die Substrate, auf welche die OLEDs aufgebracht werden. Die OLEDs haben prinzipiell folgenden Schichtaufbau: Substrat / Lochinjektionsschicht (HIL) / Lochtransportschichten (HTL) / Zwischenschicht (IL) / optionale Lochtransportschicht (HTL2), Elektronenblockerschicht (EBL) / Emissionsschicht (EML) / Elektronentransportschicht (ETL) und abschließend eine Kathode. Die Kathode wird durch eine 100 nm dicke Aluminiumschicht gebildet. Der genaue Aufbau der OLEDs ist Tabelle 1 und 3 zu entnehmen. Die zur Herstellung der OLEDs benötigten Materialien sind in Tabelle 6 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und mindestens einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie H1:SEB1 (95%:5%) bedeutet hierbei, dass das Material H1 in einem Volumenanteil von 95% und SEB1 in einem Anteil von 5% in der Schicht vorliegt. Analog kann auch die Elektronentransportschicht oder die erfindungsgemässe Lochtransportschicht aus einer Mischung von zwei Materialien bestehen.

Die OLEDs werden standardmäßig charakterisiert. Hierfür werden die Elektrolumineszenzspektren und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik bestimmt. Die Elektrolumineszenzspektren werden bei einer Leuchtdichte von 1000 cd/m² bestimmt und daraus die CIE 1931 x und y Farbkoordinaten berechnet. Die Angabe U @ 1000 cd/m² in Tabelle 2 und 4 bezeichnet die Spannung, die für eine Leuchtdichte von 1000 cd/m² benötigt wird. EQE @ 1000 cd/m² schließlich bezeichnet die externe Quanteneffizienz bei einer Betriebsleuchtdichte von 1000 cd/m². Die Daten der verschiedenen OLEDs sind in Tabelle 2 und 4 zusammengefasst.

Es wird beobachtet, dass die erfindungsgemäßen Mischungen bei Verwendung als Lochtransportmaterial verbesserte Werte für die Spannung und/oder die Leistungseffizienz aufweisen, verglichen mit den gemäß dem Stand der Technik als Einzelverbindungen eingesetzten Verbindungen. Dies zeigt sich konsistent bei allen vermessenen Mischungen, beispielhaft wird auf E8 (Mischung 8 enthaltend HTM5 und HTM6) verglichen mit V5 (HTM5) und V6 (HTM6) hingewiesen.

Die Vorteile treten auch bei Verwendung in einer OLED mit phosphoreszierendem Emitter auf, vgl. Tabelle 4.

V1 bis V12 sind vergleichsbeispiele.

| **Tabelle 1: Aufbau der OLEDs** | | | | | | | |
|---|---|---|---|---|---|---|---|
| ***Bsp.*** | ***IL*** | ***HIL*** | ***IL*** | ***HTL*** | ***EBL*** | ***EML*** | ***ETL*** |
| | *Dicke* / *nm* | *Dicke* / *nm* | *Dicke* / *nm* | *Dicke* / *nm* | *Dicke* / *nm* | *Dicke* / *nm* | *Dicke* / *nm* |
| *V1* | *HIL1 5 nm* | *HIL2 190 nm* | *HIL1 5 nm* | *HTM1 10nm* | *HTM1 10 nm* | *H1(95%): SEB1(5%) 20 nm* | *ETM1(50%): LiQ(50%) 30 nm* |
| *V2* | *HIL1 5 nm* | *HIL2 190 nm* | *HIL1* 5 *nm* | *HTM1 10 nm* | *HTM2 10 nm* | *H1(95%): SEB1(5%) 20 nm* | *ETM1(50%): LiQ(50%) 30 nm* |
| *V3* | *HIL1 5 nm* | *HIL2 190 nm* | *HIL1 5 nm* | *HTM1 10nm* | *HTM3 10 nm* | *H1(95%): SEB1(5%) 20 nm* | *ETM1(50%): LiQ(50%) 30 nm* |
| *V4* | *HIL1 5 nm* | *HIL2 190 nm* | *HIL1 5 nm* | *HTM1 10nm* | *HTM4 10 nm* | *H1 (95%): SEB1(5%)* | *ETM1(50%): LiQ(50%)* |
| | | | | | | *20 nm* | *30 nm* |
| *V5* | *HIL1 5 nm* | *HIL2 190 nm* | *HIL1 5 nm* | *HTM1 10nm* | *HTM5 10 nm* | *H1(95%): SEB1(5%) 20 nm* | *ETM1(50%): LiQ(50%) 30 nm* |
| *V6* | *HIL1 5 nm* | *HIL2 190 nm* | *HIL1 5 nm* | *HTM1 10nm* | *HTM6 10 nm* | *H1(95%): SEB1(5%) 20 nm* | *ETM1(50%): LiQ(50%) 30 nm* |
| *E1* | *HIL1 5 nm* | *HIL2 190 nm* | *HIL1 5 nm* | *HTM1 10nm* | *HTM2(50%): HTM3(50%) 10 nm* | *H1 (95%): SEB1(5%) 20 nm* | *ETM1(50%): LiQ(50%) 30 nm* |
| *E2* | *HIL1 5 nm* | *HIL2 190 nm* | *HIL1 5nm* | *HTM1 10nm* | *HTM1(50%): HTM5(50%) 10 nm* | *H1(95%): SEB1(5%) 20 nm* | *ETM1(50%): LiQ(50%) 30 nm* |
| *E3* | *HIL1 5 nm* | *HIL2 190 nm* | *HIL1 5 nm* | *HTM1 10nm* | *HTM1(50%): HTM2(50%) 10 nm* | *H1(95%): SEB1(5%) 20 nm* | *ETM1(50%): LiQ(50%) 30 nm* |
| *E4* | *HIL1 5 nm* | *HIL2 190 nm* | *HIL1 5 nm* | *HTM1 10nm* | *HTM2(33.3%): HTM3(33.3%): HTM4(33.3%) 10 nm* | *H1 (95%): SEB1(5%) 20 nm* | *ETM1(50%): LiQ(50%) 30 nm* |
| *E5* | *HIL1 5 nm* | *HIL2 190 nm* | *HIL1 5 nm* | *HTM1 10 nm* | *HTM1(33.3%): HTM2(33.3%): HTM5(33.3%) 10 nm* | *H1 (95%): SEB1(5%) 20 nm* | *ETM1(50%): LiQ(50%) 30 nm* |
| *E6* | *HIL1 5 nm* | *HIL2 190 nm* | *HIL1 5 nm* | *HTM1 10nm* | *HTM1(33.3%): HTMS(33.3%): HTM6(33.3%) 10 nm* | *H1(95%): SEB1(5%) 20 nm* | *ETM1(50%): LiQ(50%) 30 nm* |
| *E7* | *HIL1 5 nm* | *HIL2 190 nm* | *HIL1 5 nm* | *HTM1 10nm* | *HTM3(50%): HTM4(50%) 10 nm* | *H1(95%): SEB1(5%) 20 nm* | *ETM1(50%): LiQ(50%) 30 nm* |
| *E8* | *HIL1 5 nm* | *HIL2 190 nm* | *HIL1 5 nm* | *HTM1 10nm* | *HTMS(50%): HTM6(50%) 10 nm* | *H1 (95%): SEB1(5%) 20 nm* | *ETM1(50%): LiQ(50%) 30 nm* |
| *E9* | *HIL1* | *HIL2* | *HIL1* | *HTM1* | *HTM2(50%):* | *H1(95%):* | *ETM1(50%):* |
| | *5 nm* | *190 nm* | *5 nm* | *10nm* | *HTM4(50%) 10 nm* | *SEB1(5%) 20 nm* | *LiQ(50%) 30 nm* |

| **Tabelle 2: Daten der OLEDs von Tab. 1** | | | | |
|---|---|---|---|---|
| ***Bsp.*** | **U@ *1000 cd*/*m2*** | ***EQE* @ *1000 cd*/*m2*** | ***C*/*E*** | |
| | *V* | *%* | *x* | *y* |
| *V1* | *4.0* | *8.1* | 0.14 | 0.16 |
| *V2* | *4.1* | *8.3* | 0.14 | 0.16 |
| *V3* | *4.1* | *8.4* | 0.14 | 0.16 |
| *V4* | *4.1* | *8.3* | 0.14 | 0.16 |
| *V5* | *4.3* | *8.5* | 0.14 | 0.16 |
| *V6* | *4.3* | *8.5* | 0.14 | 0.16 |
| *E1* | *4.0* | *8.3* | 0.14 | 0.16 |
| *E2* | *4.1* | *8.4* | 0.14 | 0.16 |
| *E3* | *3.9* | *8.2* | 0.14 | 0.16 |
| *E4* | *3.9* | *8.3* | 0.14 | 0.16 |
| *E5* | *4.1* | *8.3* | 0.14 | 0.16 |
| *E6* | *4.2* | *8.4* | 0.14 | 0.16 |
| *E7* | *4.0* | *8.3* | 0.14 | 0.16 |
| *E8* | *4.2* | *8.5* | 0.14 | 0.16 |
| *E9* | *4.0* | *8.3* | 0.14 | 0.16 |

| **Tabelle 3: Aufbau der OLEDs** | | | | | | | |
|---|---|---|---|---|---|---|---|
| ***Bsp.*** | ***IL*** | ***HIL*** | ***IL*** | ***HTL*** | ***EBL*** | ***EML*** | ***ETL*** |
| | *Dicke* / *nm* | *Dicke* / *nm* | *Dicke* / *nm* | *Dicke* / *nm* | *Dicke* / *nm* | *Dicke* / *nm* | *Dicke* / *nm* |
| *V7* | *HIL1 5 nm* | *HIL2 220 nm* | *HIL1 5 nm* | *HTM1 10nm* | *HTM1 10 nm* | *H2(88%): Irpy(12%) 30 nm* | *ETM1(50%): LiQ(50%) 40 nm* |
| *V8* | *HIL1 5 nm* | *HIL2 220 nm* | *HIL1 5 nm* | *HTM1 10nm* | *HTM2 10 nm* | *H2(88%): Irpy(12%) 30 nm* | *ETM1(50%): LiQ(50%) 40 nm* |
| *V9* | *HIL1 5 nm* | *HIL2 220 nm* | *HIL1 5 nm* | *HTM1 10nm* | *HTM3 10 nm* | *H2(88%): Irpy(12%) 30 nm* | *ETM1(50%): LiQ(50%) 40 nm* |
| *V10* | *HIL1 5 nm* | *HIL2 220 nm* | *HIL1 5 nm* | *HTM1 10nm* | *HTM4 10 nm* | *H2(88%): Irpy(12%) 30 nm* | *ETM1(50%): LiQ(50%) 40 nm* |
| *V11* | *HIL1 5 nm* | *HIL2 220 nm* | *HIL1 5 nm* | *HTM1 10nm* | *HTM5 10 nm* | *H2(88%): Irpy(12%) 30 nm* | *ETM1(50%): LiQ(50%) 40 nm* |
| *V12* | *HIL1 5 nm* | *HIL2 220 nm* | *HIL1 5 nm* | *HTM1 10nm* | *HTM6 10 nm* | *H2(88%): Irpy(12%) 30 nm* | *ETM1(50%): LiQ(50%) 40 nm* |
| *E10* | *HIL1 5 nm* | *HIL2 220 nm* | *HIL1 5 nm* | *HTM1 10nm* | *HTM2(50%): HTM3(50%) 10 nm* | *H2(88%): Irpy(12%) 30 nm* | *ETM1(50%): LiQ(50%) 40 nm* |
| *E11* | *HIL1 5 nm* | *HIL2 220 nm* | *HIL1 5 nm* | *HTM1 10nm* | *HTM1(50%): HTMS(50%) 10 nm* | *H2(88%): Irpy(12%) 30 nm* | *ETM1(50%): LiQ(50%) 40 nm* |
| *E12* | *HIL1 5 nm* | *HIL2 220 nm* | *HIL1 5 nm* | *HTM1 10nm* | *HTM1(50%): HTM2(50%) 10 nm* | *H2(88%): Irpy(12%) 30 nm* | *ETM1(50%): LiQ(50%) 40 nm* |
| *E13* | *HIL1 5 nm* | *HIL2 220 nm* | *HIL1 5 nm* | *HTM1 10nm* | *HTM2(33.3%): HTM3(33.3%): HTM4(33.3%) 10 nm* | *H2(88%): Irpy(12%) 30 nm* | *ETM1(50%): LiQ(50%) 40 nm* |
| *E14* | *HIL1 5 nm* | *HIL2 220 nm* | *HIL1 5 nm* | *HTM1 10nm* | *HTM1(33.3%): HTM2(33.3%): HTMS*(*33*.*3%) 10 nm* | *H2(88%): Irpy(12%) 30 nm 30 nm* | *ETM1(50%): LiQ(50%) 40 nm 40 nm* |
| *E15* | *HIL1 5 nm* | *HIL2 220 nm* | *HIL1 5 nm* | *HTM1 10 nm* | *HTM1(33.3%): HTM5(33.3%): HTM6(33.3%) 10 nm* | *H2(88%): Irpy(12%) 30 nm* | *ETM1(50%): LiQ(50%) 40 nm* |
| *E16* | *HIL1 5 nm* | *HIL2 220 nm* | *HIL1 5 nm* | *HTM1 10nm* | *HTM3(50%): HTM4(50%) 10 nm* | *H2(88%): Irpy(12%) 30 nm* | *ETM1(50%): LiQ(50%) 40 nm* |
| *E17* | *HIL1 5 nm* | *HIL2 220 nm* | *HIL1 5 nm* | *HTM3 10nm* | *HTMS(50%): HTM6(50%) 10 nm* | *H2(88%): Irpy(12%) 30 nm* | *ETM1(50%): LiQ(50%) 40 nm* |
| *E18* | *HIL1 5 nm* | *HIL2 220 nm* | *HIL1 5 nm* | *HTM1 10nm* | *HTM2(50%): HTM4(50%) 10 nm* | *H2(88%): Irpy(12%) 30 nm* | *ETM1(50%): LiQ(50%) 40 nm* |

| **Tabelle 4: Daten der OLEDs aus Tab. 3** | | | | |
|---|---|---|---|---|
| *Bsp.* | U@ *1000 cd*/*m2* | *EQE* @ *1000 cd*/*m2* | *C*/*E* | |
| | *V* | % | *x* | y |
| *V7* | *3.6* | *17.8* | 0.32 | 0.63 |
| *V8* | *3.7* | *18.1* | 0.32 | 0.63 |
| *V9* | *3.7* | *18.5* | 0.32 | 0.63 |
| *V10* | *3.7* | *18.3* | 0.32 | 0.63 |
| *V11* | *3.9* | *18.7* | 0.32 | 0.63 |
| *V12* | *3.9* | *18.9* | 0.32 | 0.63 |
| *E10* | *3. 6* | *18.1* | 0.32 | 0.63 |
| *E11* | *3.7* | *18.5* | 0.32 | 0.63 |
| *E12* | *3.5* | *18.2* | 0.32 | 0.63 |
| *E13* | *3.5* | *18.3* | 0.32 | 0.63 |
| *E14* | *3.7* | *18.3* | 0.32 | 0.63 |
| *E15* | *3.8* | *18.4* | 0.32 | 0.63 |
| *E16* | *3.6* | *18.3* | 0.32 | 0.63 |
| *E17* | *3.8* | *18.7* | 0.32 | 0.63 |
| *E18* | *3.6* | *18.1* | 0.32 | 0.63 |

### Beispiel 3: Verhalten der OLEDs beim Tempern

Es werden OLEDs mit dem in Tabelle 1 und 3 gezeigten Aufbau verwendet.

OLEDs, die die erfindungsgemässen Mischungen enthalten, zeigen keine reduzierte Effizienz, wenn sie für 1 Stunde bei einer Temperatur, die der Glasübergangstemperatur Tg derjenigen Einzelverbindung mit der höchsten Glasübergangstemperatur entspricht, gelagert werden (Tabelle 5, E7, E9, E16 und E18).

Im Gegensatz dazu zeigen die Effizienzen der Vergleichs-OLEDs unter den gleichen Lagerungsbedingungen (Tabelle 5, V2-V4 und V8-V10) eine deutlich reduzierte Effizienz (> 10%, die genaue Effizienzverminderung ist von der Kinetik jedes einzelnen OLED Devices abhängig, so dass lediglich der günstigste Wert gezeigt wird).

| **Tabelle 5: Änderung, der OLED-Effizienz nach Tempern** | | | |
|---|---|---|---|
| ***Bsp.*** | ***EQE*** @ ***1000 cd*/*m2 vor Tempern*** | ***EQE* @ *1000 cd*/*m2 nach 1 h Tempern*** | ***Temperatur*** |
| | % | % | **°C** |
| *V2* | *8.3* | <*7.1* | *63* |
| *V3* | *8.4* | *<7.2* | *67* |
| *V4* | *8.3* | *<7.1* | *67* |
| *V8* | *18.1* | *<16.0* | *63* |
| *V9* | *18.5* | *<16.5* | *67* |
| *V10* | *18.3* | *<16.1* | *67* |
| *E7* | *8.3* | *8.2* | *67* |
| *E9* | *8.3* | *8.3* | *63* |
| *E16* | *18.3* | *18.1* | *67* |
| *E18* | *18.1* | *18.0* | *63* |

| **Tabelle 6: Strukturen der verwendeten Materialien** | | |
|---|---|---|
| 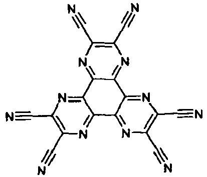 | 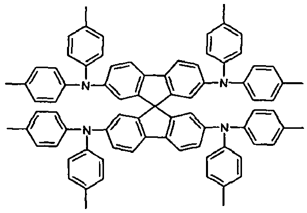 | 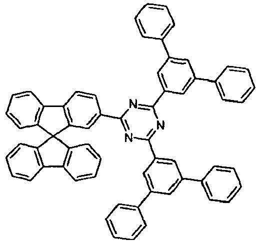 |
| HIL1 | HIL2 | ETM1 |
| 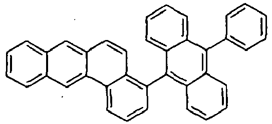 | 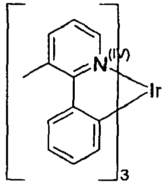 | 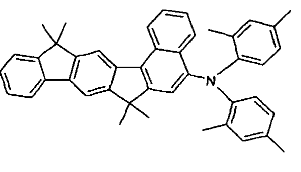 |
| H1 | Irpy | SEB1 |
| 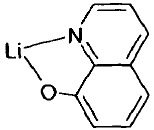 | 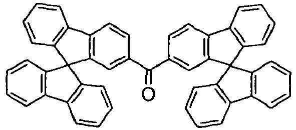 | |
| LiQ | H2 | |
| 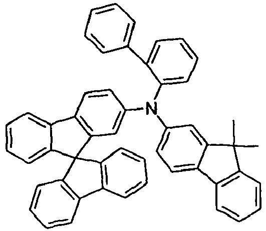 | 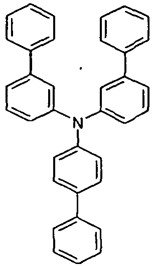 | 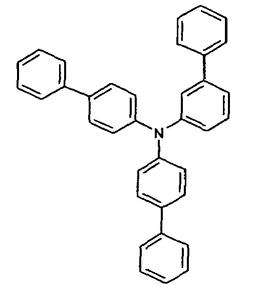 |
| HTM1 | HTM2 | HTM3 |
| 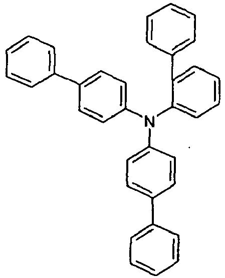 | 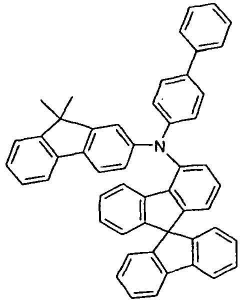 | 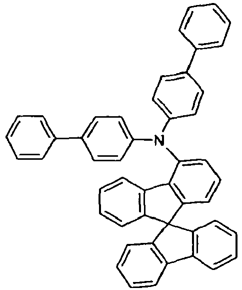 |
| HTM4 | HTM5 | HTM6 |

### Synthese der Verbindungen HTM1-HTM6:

Einige der Verbindungen sind mit ihrer Synthese im Stand der Technik bekannt. In allen Fällen ist die Synthese ähnlicher Verbindungen im Stand der Technik bekannt. Synthese und Verwendung von HTM4 ist in der noch nicht offengelegten Anmeldung EP 11009779.7 beschrieben. Synthese und Verwendung von HTM5 und HTM6 sind in der noch nicht offengelegten Anmeldung EP 12000929.5 beschrieben.

## Patentansprüche

1. Mischung enthaltend zwei oder mehr verschiedene Verbindungen der Formel (I) 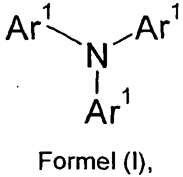 wobei für die Verbindungen der Formel (I) gilt:
Ar¹ ist bei jedem Auftreten gleich oder verschieden ein aromatisches oder heteroaromatisches Ringsystem mit 5 bis 60 aromatischen Ringatomen, das mit einem oder mehreren Resten R¹ substituiert sein kann;
R¹ ist bei jedem Auftreten gleich oder verschieden H, D, F, C(=O)R², CN, Si(R²)₃, P(=O)(R²)₂, S(=O)R², S(=O)₂R², eine geradkettige Alkyl-, Alkoxy- oder Thioalkylgruppe mit 1 bis 20 C-Atomen oder eine verzweigte oder cyclische Alkyl-, Alkoxy-oder Thioalkylgruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R² substituiert sein können und wobei eine oder mehrere CH₂-Gruppen in den oben genannten Gruppen durch -R²C=CR²-, -C≡C-, Si(R²)₂, C=O, C=S, C=NR², -C(=O)O-, -C(=O)NR²-, P(=O)(R²), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Aryloxy- oder Heteroaryloxygruppe mit 5 bis 30 aromatischen Ringatomen, die durch einen oder mehrere Reste R² substituiert sein kann, wobei zwei oder mehr Reste R¹ miteinander verknüpft sein können und einen Ring bilden können;
R² ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden;
wobei eine, zwei oder drei Gruppen Ar¹ gleich oder verschieden gewählt sind aus aromatischen Ringsystemen mit 12 bis 60 aromatischen Ringatomen, die mit einem oder mehreren Resten R¹ substituiert sein können.

2. Mischung nach Anspruch 1, **dadurch gekennzeichnet, dass** sie genau zwei, drei oder vier verschiedene Verbindungen der Formel (I) enthält.

3. Mischung nach Anspruch 1 oder 2, **dadurch gekennzeichnet, dass** sie weniger als 10 % an Verbindungen enthält, die nicht Formel (I) entsprechen.

4. Mischung nach einem oder mehreren der Ansprüche 1 bis 3, **dadurch gekennzeichnet, dass** sie einen oder mehrere p-Dotanden enthält.

5. Mischung nach einem oder mehreren der Ansprüche 1 bis 4, **dadurch gekennzeichnet, dass** die mindestens zwei Verbindungen der Formel (I) jede für sich gesehen einen Anteil von mindestens 10 % aufweisen.

6. Mischung nach einem oder mehreren der Ansprüche 1 bis 5, **dadurch gekennzeichnet, dass** die mindestens zwei Verbindungen gemäß Formel (I) außer dem in Formel (I) gezeigten Stickstoffatom kein weiteres Stickstoffstoffatom aufweisen, das drei Substituenten trägt.

7. Mischung nach einem oder mehreren der Ansprüche 1 bis 6, **dadurch gekennzeichnet, dass** zwei oder drei Gruppen Ar¹ gewählt sind aus aromatischen Ringsystemen mit 12 bis 60 aromatischen Ringatomen, welche mit einem oder mehreren Resten R¹ substituiert sein können.

8. Mischung nach einem oder mehreren der Ansprüche 1 bis 7, **dadurch gekennzeichnet, dass** mindestens eine Gruppe Ar¹ in den Verbindungen der Formel (I) der Formel (II), (III) oder (IV) entspricht 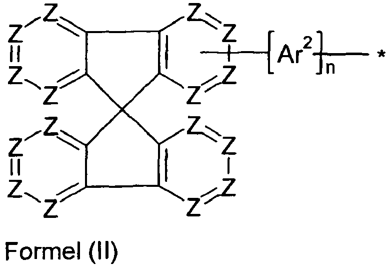 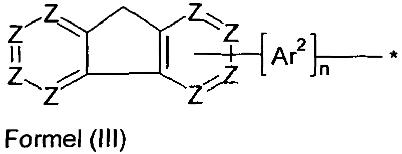 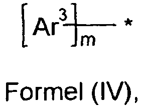 wobei die markierte Bindung der Bindung an das Stickstoffatom entspricht,
Z bei jedem Auftreten gleich oder verschieden CR¹ oder N ist, wobei nicht mehr als 2 benachbarte Gruppen Z für N stehen,
Ar² und Ar³ bei jedem Auftreten gleich oder verschieden eine Aryl- oder Heteroarylgruppe mit 5 bis 10 aromatischen Ringatomen ist, die mit einem oder mehreren Resten R¹, wie in Anspruch 1 definiert, substituiert sein kann,
n einen Wert von 0 bis 3 hat,
m einen Wert von 2 bis 4 hat,
und die Gruppen der Formel (II), (III) und (IV) an allen freien Positionen mit Resten R¹, wie in Anspruch 1 definiert, substituiert sein können.

9. Mischung nach Anspruch 8, **dadurch gekennzeichnet, dass** mindestens zwei Gruppen Ar¹ in den mindestens zwei Verbindungen gemäß Formel (I) einer der Formeln (II), (III) oder (IV) entsprechen.

10. Mischung nach einem oder mehreren der Ansprüche 1 bis 9, **dadurch gekennzeichnet, dass** mindestens eine der mindestens zwei Verbindungen gemäß Formel (I) einer der Formeln (V) bis (IX) entspricht 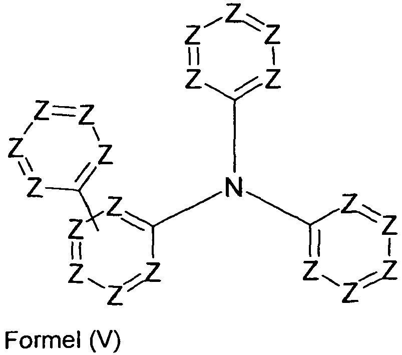 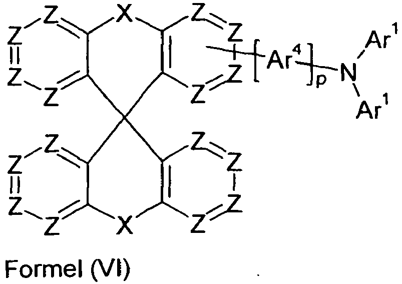 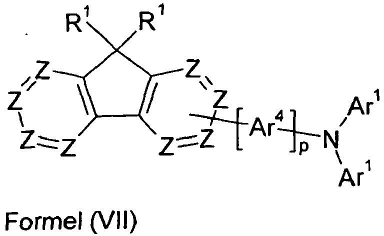 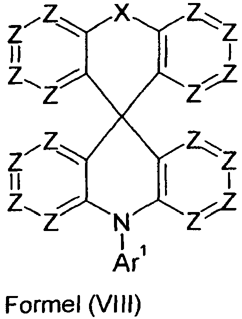 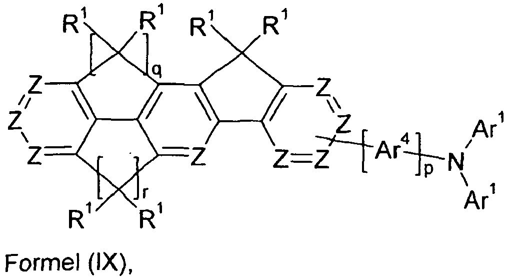 wobei folgendes gilt:
Z ist bei jedem Auftreten gleich oder verschieden CR¹ oder N, wobei nicht mehr als zwei benachbarte Gruppen Z für N stehen.
X ist bei jedem Auftreten gleich oder verschieden eine Einfachbindung, O, S, Se, BR¹, C(R¹)₂, Si(R¹)₂, NR¹, PR¹, C(R¹)₂-C(R¹)₂, oder CR¹=CR¹;
Ar¹ ist definiert wie in Anspruch 1;
Ar⁴ ist bei jeden Auftreten gleich oder verschieden ein aromatisches oder heteroaromatisches Ringsystem mit 5 bis 30 aromatischen Ringatomen, welches durch einen oder mehrere Reste R¹ substituiert sein kann;
R¹ ist definiert wie in Anspruch 1;
R² ist definiert wie in Anspruch 1;
p ist gleich 0 oder 1;
q, r sind gleich oder verschieden 0 oder 1, wobei die Summe aus q und r gleich 1 oder 2 ist.

11. Formulierung enthaltend eine Mischung nach einem oder mehreren der Ansprüche 1 bis 10 sowie mindestens ein Lösungsmittel.

12. Elektronische Vorrichtung, ausgewählt aus der Gruppe bestehend aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs), **dadurch gekennzeichnet, dass** sie eine Mischung nach einem oder mehreren der Ansprüche 1 bis 10 in einer organischen Schicht enthält.

13. Elektronische Vorrichtung nach Anspruch 12, gewählt aus organischen Elektrolumineszenzvorrichtungen, **dadurch gekennzeichnet, dass** die Mischung nach einem oder mehreren der Ansprüche 1 bis 10 in einer Lochtransportschicht verwendet wird.

14. Organische Elektroluminenzenzvorrichtung nach Anspruch 13, **dadurch gekennzeichnet, dass** sie zusätzlich mindestens eine weitere Lochtransportschicht enthält, die anodenseitig von der Lochtransportschicht enthaltend die Mischung nach einem oder mehreren der Ansprüche 1 bis 10 angeordnet ist.

15. Verwendung einer Mischung nach einem oder mehreren der Ansprüche 1 bis 10 in einer elektronischen Vorrichtung, ausgewählt aus der Gruppe bestehend aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs).

## Claims

1. Mixture comprising two or more different compounds of the formula (I) 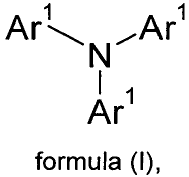 where the following applies to the compounds of the formula (I):
Ar¹ is on each occurrence, identically or differently, an aromatic or heteroaromatic ring system having 5 to 60 aromatic ring atoms, which may be substituted by one or more radicals R¹;
R¹ is on each occurrence, identically or differently, H, D, F, C(=O)R², CN, Si(R²)₃, P(=O)(R²)₂, S(=O)R², S(=O)₂R², a straight-chain alkyl, alkoxy or thioalkyl group having 1 to 20 C atoms or a branched or cyclic alkyl, alkoxy or thioalkyl group having 3 to 20 C atoms or an alkenyl or alkynyl group having 2 to 20 C atoms, where the above-mentioned groups may each be substituted by one or more radicals R² and where one or more CH₂ groups in the above-mentioned groups may be replaced by -R²C=CR²-, -C≡C-, Si(R²)₂, C=O, C=S, C=NR², -C(=O)O-, -C(=O)NR²-, P(=O)(R²), -O-, -S-, SO or SO₂ and where one or more H atoms in the above-mentioned groups may be replaced by D, F or CN, or an aromatic or heteroaromatic ring system having 5 to 30 aromatic ring atoms, which may in each case be substituted by one or more radicals R², or an aryloxy or hetero-aryloxy group having 5 to 30 aromatic ring atoms, which may be substituted by one or more radicals R², where two or more radicals R¹ may be linked to one another and may form a ring;
R² is on each occurrence, identically or differently, H, D, F or an aliphatic, aromatic or heteroaromatic organic radical having 1 to 20 C atoms, in which, in addition, one or more H atoms may be replaced by D or F; two or more substituents R² here may be linked to one another and may form a ring;
where one, two or three groups Ar¹ are selected, identically or differently, from aromatic ring systems having 12 to 60 aromatic ring atoms, which may be substituted by one or more radicals R¹.

2. Mixture according to Claim 1, **characterised in that** it comprises precisely two, three or four different compounds of the formula (I).

3. Mixture according to Claim 1 or 2, **characterised in that** it comprises less than 10% of compounds which do not conform to formula (I).

4. Mixture according to one or more of Claims 1 to 3, **characterised in that** it comprises one or more p-dopants.

5. Mixture according to one or more of Claims 1 to 4, **characterised in that** the at least two compounds of the formula (I), each considered individually, have a proportion of at least 10%.

6. Mixture according to one or more of Claims 1 to 5, **characterised in that** the at least two compounds of the formula (I) contain no further nitrogen atom which carries three substituents apart from the nitrogen atom shown in formula (I).

7. Mixture according to one or more of Claims 1 to 6, **characterised in that** two or three groups Ar¹ are selected from aromatic ring systems having 12 to 60 aromatic ring atoms, which may be substituted by one or more radicals R¹.

8. Mixture according to one or more of Claims 1 to 7, **characterised in that** at least one group Ar¹ in the compounds of the formula (I) conforms to the formula (II), (III) or (IV) 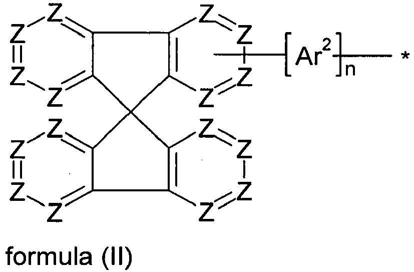 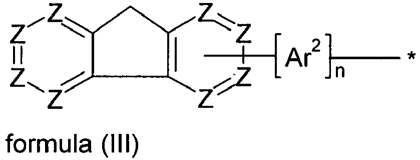 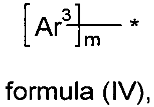 where the marked bond corresponds to the bond to the nitrogen atom,
Z is on each occurrence, identically or differently, CR¹ or N, where not more than 2 adjacent groups Z stand for N,
Ar² and Ar³ are on each occurrence, identically or differently, an aryl or heteroaryl group having 5 to 10 aromatic ring atoms, which may be substituted by one or more radicals R¹, as defined in Claim 1,
n has a value of 0 to 3,
m has a value of 2 to 4,
and the groups of the formulae (II), (III) and (IV) may be substituted by radicals R¹, as defined in Claim 1, at all free positions.

9. Mixture according to Claim 8, **characterised in that** at least two groups Ar¹ in the at least two compounds of the formula (I) conform to one of the formulae (II), (III) or (IV).

10. Mixture according to one or more of Claims 1 to 9, **characterised in that** at least one of the at least two compounds of the formula (I) conforms to one of the formulae (V) to (IX) 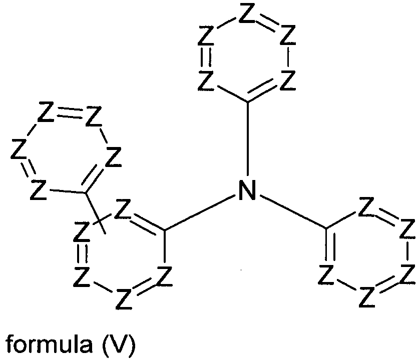 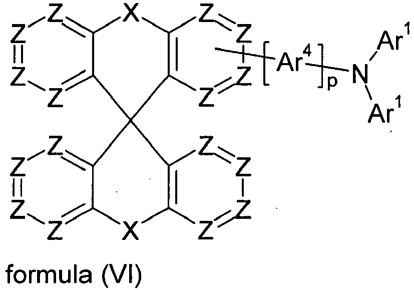 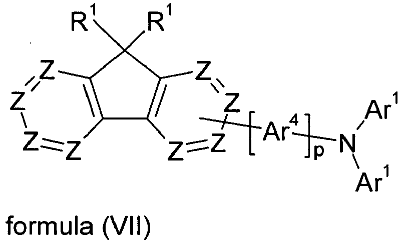 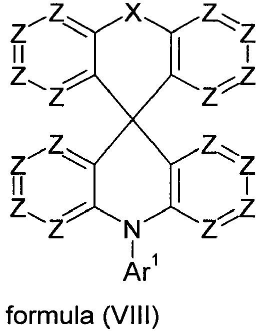 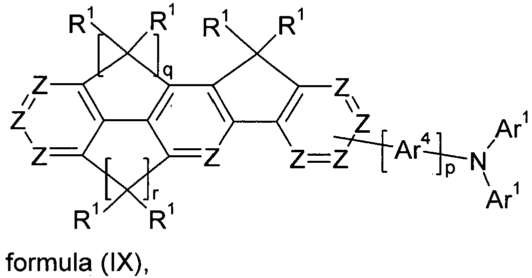 where the following applies:
Z is on each occurrence, identically or differently, CR¹ or N, where not more than two adjacent groups Z stand for N;
X is on each occurrence, identically or differently, a single bond, O, S, Se, BR¹, C(R¹)₂, Si(R¹)₂, NR¹, PR¹, C(R¹)₂-C(R¹)₂ or CR¹=CR¹;
Ar¹ is defined as in Claim 1;
Ar⁴ is on each occurrence, identically or differently, an aromatic or heteroaromatic ring system having 5 to 30 aromatic ring atoms, which may be substituted by one or more radicals R¹;
R¹ is defined as in Claim 1;
R² is defined as in Claim 1;
p is equal to 0 or 1;
q, r are, identically or differently, 0 or 1, where the sum of q and r is equal to 1 or 2.

11. Formulation comprising a mixture according to one or more of Claims 1 to 10 and at least one solvent.

12. Electronic device selected from the group consisting of organic integrated circuits (OICs), organic field-effect transistors (OFETs), organic thin-film transistors (OTFTs), organic light-emitting transistors (OLETs), organic solar cells (OSCs), organic optical detectors, organic photoreceptors, organic field-quench devices (OFQDs), organic light-emitting electrochemical cells (OLECs), organic laser diodes (O-lasers) and organic electroluminescent devices (OLEDs), **characterised in that** it comprises a mixture according to one or more of Claims 1 to 10 in an organic layer.

13. Electronic device according to Claim 12, selected from organic electroluminescent devices, **characterised in that** the mixture according to one or more of Claims 1 to 10 is used in a hole-transport layer.

14. Organic electroluminescent device according to Claim 13, **characterised in that** it additionally comprises at least one further hole-transport layer which is arranged on the anode side of the hole-transport layer comprising the mixture according to one or more of Claims 1 to 10.

15. Use of a mixture according to one or more of Claims 1 to 10 in an electronic device selected from the group consisting of organic integrated circuits (OICs), organic field-effect transistors (OFETs), organic thin-film transistors (OTFTs), organic light-emitting transistors (OLETs), organic solar cells (OSCs), organic optical detectors, organic photoreceptors, organic field-quench devices (OFQDs), organic light-emitting electrochemical cells (OLECs), organic laser diodes (O-lasers) and organic electroluminescent devices (OLEDs).

## Revendications

1. Mélange comprenant deux composés différents ou plus de la formule (I) : 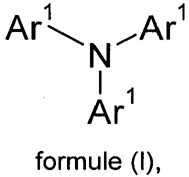 dans laquelle ce qui suit s'applique aux composés de la formule (I) :
Ar¹ est, pour chaque occurrence, de manière identique ou différente, un système de cycle aromatique ou hétéroaromatique comportant 5 à 60 atomes de cycle aromatique, lequel peut être substitué par un radical ou plusieurs radicaux R¹ ;
R¹ est, pour chaque occurrence, de manière identique ou différente, H, D, F, C(=O)R², CN, Si(R²)₃, P(=O)(R²)₂, S(=O)R², S(=O)₂R², un groupe alkyle, alcoxy ou thioalkyle en chaîne droite comportant 1 à 20 atome(s) de C ou un groupe alkyle, alcoxy ou thioalkyle ramifié ou cyclique comportant 3 à 20 atomes de C ou un groupe alkényle ou alkynyle comportant 2 à 20 atomes de C, où les groupes mentionnés ci avant peuvent chacun être substitués par un radical ou plusieurs radicaux R² et où un ou plusieurs groupe(s) CH₂ dans les groupes mentionnés ci avant peut/peuvent être remplacé(s) par -R²C=CR²-, -C≡C-, Si(R²)₂, C=O, C=S, C=NR², -C(=O)O-, -C(=O)NR²-, P(=O)(R²), -O-, -S-, SO ou SO₂ et où un ou plusieurs atome(s) de H dans les groupes mentionnés ci avant peut/peuvent être remplacé(s) par D, F ou CN, ou un système de cycle aromatique ou hétéroaromatique comportant 5 à 30 atomes de cycle aromatique, lequel peut dans chaque cas être substitué par un radical ou plusieurs radicaux R², ou un groupe aryloxy ou hétéroaryloxy comportant 5 à 30 atomes de cycle aromatique, lequel peut être substitué par un radical ou plusieurs radicaux R², où deux radicaux R¹ ou plus peuvent être liés l'un à l'autre ou les uns aux autres et peuvent former un cycle ;
R² est, pour chaque occurrence, de manière identique ou différente, H, D, F ou un radical organique aliphatique, aromatique ou hétéroaromatique comportant 1 à 20 atome(s) de C, où, en outre, un ou plusieurs atome(s) de H peut/peuvent être remplacé(s) par D ou F ; deux substituants R² ou plus peuvent ici être liés l'un à l'autre ou les uns aux autres et peuvent former un cycle ;
où un, deux ou trois groupe(s) Ar¹ est/sont sélectionné(s), de manière identique ou différente, parmi des systèmes de cycle aromatique comportant 12 à 60 atomes de cycle aromatique, lesquels peuvent être substitués par un radical ou plusieurs radicaux R¹.

2. Mélange selon la revendication 1, **caractérisé en ce qu'**il comprend précisément deux, trois ou quatre composés différents de la formule (I).

3. Mélange selon la revendication 1 ou 2, **caractérisé en ce qu'**il comprend moins de 10% de composés qui ne sont pas conformes à la formule (I).

4. Mélange selon une ou plusieurs des revendications 1 à 3, **caractérisé en ce qu'**il comprend un ou plusieurs dopant(s) p.

5. Mélange selon une ou plusieurs des revendications 1 à 4, **caractérisé en ce que** les au moins deux composés de la formule (I), chacun considéré individuellement, présentent une proportion d'au moins 10%.

6. Mélange selon une ou plusieurs des revendications 1 à 5, **caractérisé en ce que** les au moins deux composés de la formule (I) ne contiennent pas d'atome d'azote supplémentaire porteur de trois substituants en dehors de l'atome d'azote présenté selon la formule (I).

7. Mélange selon une ou plusieurs des revendications 1 à 6, **caractérisé en ce que** deux ou trois groupes Ar¹ sont sélectionnés parmi des systèmes de cycle aromatique comportant 12 à 60 atomes de cycle aromatique, lesquels peuvent être substitués par un radical ou plusieurs radicaux R¹.

8. Mélange selon une ou plusieurs des revendications 1 à 7, **caractérisé en ce qu'**au moins un groupe Ar¹ dans les composés de la formule (I) est conforme à la formule (II), (III) ou (IV) : 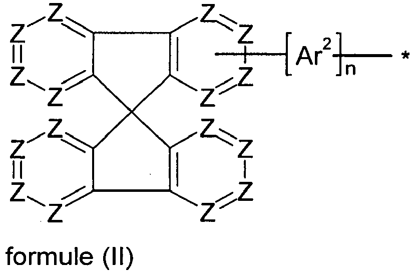 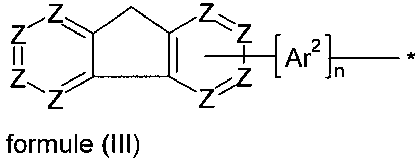 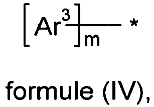 dans lesquelles la liaison marquée correspond à la liaison sur l'atome d'azote,
Z est, pour chaque occurrence, de manière identique ou différente, CR¹ ou N, où pas plus de 2 groupes adjacents Z représentent N,
Ar² et Ar³ sont, pour chaque occurrence, de manière identique ou différente, un groupe aryle ou hétéroaryle comportant 5 à 10 atomes de cycle aromatique, lequel peut être substitué par un radical ou plusieurs radicaux R¹, comme défini selon la revendication 1,
n présente une valeur de 0 à 3,
m présente une valeur de 2 à 4,
et les groupes des formules (II), (III) et (IV) peuvent être substitués par des radicaux R¹, comme défini selon la revendication 1, au niveau de toutes les positions libres.

9. Mélange selon la revendication 8, **caractérisé en ce qu'**au moins deux groupes Ar¹ dans les au moins deux composés de la formule (I) sont conformes à l'une des formules (II), (III) et (IV).

10. Mélange selon une ou plusieurs des revendications 1 à 9, **caractérisé en ce qu'**au moins l'un des au moins deux composés de la formule (I) est conforme à l'une des formules (V) à (IX) : 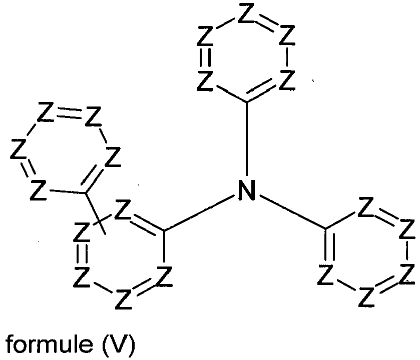 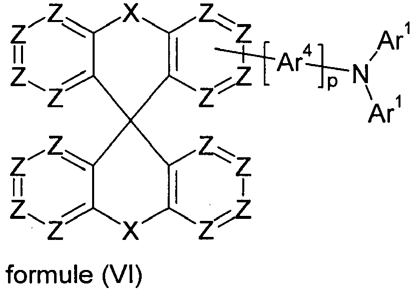 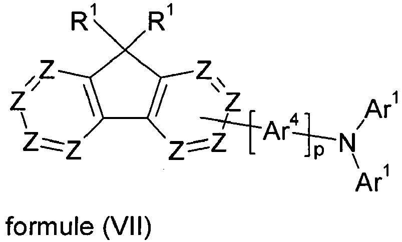 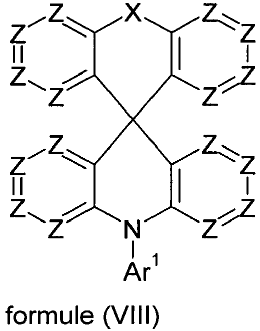 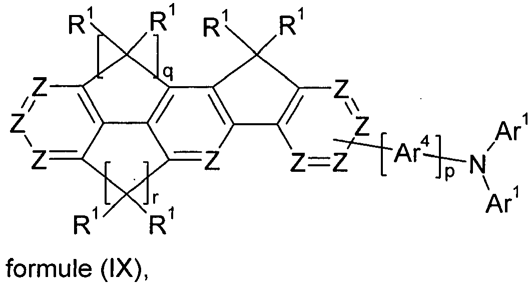 dans lesquelles ce qui suit s'applique :
Z est, pour chaque occurrence, de manière identique ou différente, CR¹ ou N, où pas plus de deux groupes adjacents Z représentent N ;
X est, pour chaque occurrence, de manière identique ou différente, une liaison simple, O, S, Se, BR¹, C(R¹)₂, Si(R¹)₂, NR¹, PR¹, C(R¹)₂-C(R¹)₂ ou CR¹=CR¹ ;
Ar¹ est défini comme selon la revendication 1 ;
Ar⁴ est, pour chaque occurrence, de manière identique ou différente, un système de cycle aromatique ou hétéroaromatique comportant 5 à 30 atomes de cycle aromatique, lequel peut être substitué par un radical ou plusieurs radicaux R¹ ;
R¹ est défini comme selon la revendication 1 ;
R² est défini comme selon la revendication 1 ;
p est égal à 0 ou 1 ;
q, r sont, de manière identique ou différente, 0 ou 1, où la somme de q et r est égale à 1 ou 2.

11. Formulation comprenant un mélange selon une ou plusieurs des revendications 1 à 10 et au moins un solvant.

12. Dispositif électronique sélectionné parmi le groupe constitué par les circuits intégrés organiques (OIC), les transistors à effet de champ organiques (OFET), les transistors à film mince organiques (OTFT), les transistors à émission de lumière organiques (OLET), les cellules solaires organiques (OSC), les détecteurs optiques organiques, les photorécepteurs organiques, les dispositifs à extinction de champ organiques (OFQD), les cellules électrochimiques à émission de lumière organiques (OLEC), les diodes laser organiques (O-laser) et les dispositifs électroluminescents organiques (OLED), **caractérisé en ce qu'**il comprend un mélange selon une ou plusieurs des revendications 1 à 10 dans une couche organique.

13. Dispositif électronique selon la revendication 12, sélectionné parmi les dispositifs électroluminescents organiques, **caractérisé en ce que** le mélange selon une ou plusieurs des revendications 1 à 10 est utilisé dans une couche de transport de trous.

14. Dispositif électroluminescent organique selon la revendication 13, **caractérisé en ce qu'**il comprend de façon additionnelle au moins une couche de transport de trous supplémentaire qui est agencée sur le côté d'anode de la couche de transport de trous comprenant le mélange selon une ou plusieurs des revendications 1 à 10.

15. Utilisation d'un mélange selon une ou plusieurs des revendications 1 à 10 dans un dispositif électronique sélectionné parmi le groupe constitué par les circuits intégrés organiques (OIC), les transistors à effet de champ organiques (OFET), les transistors à film mince organiques (OTFT), les transistors à émission de lumière organiques (OLET), les cellules solaires organiques (OSC), les détecteurs optiques organiques, les photorécepteurs organiques, les dispositifs à extinction de champ organiques (OFQD), les cellules électrochimiques à émission de lumière organiques (OLEC), les diodes laser organiques (O-laser) et les dispositifs électroluminescents organiques (OLED).
